# EUROPÄISCHE PATENTSCHRIFT

(11) **EP 1 647 035 B1**
(45) Veröffentlichungstag und Bekanntmachung des Hinweises auf die Patenterteilung: **10.04.2013**
(21) Anmeldenummer: 04738918.4
(22) Anmeldetag: 19.07.2004
(51) Int. Cl.: H01F 41/30, H01L 29/66, H01L 43/10, B82Y 25/00, H01F 10/32

(54) **BAUTEIL MIT EINEM STRUKTURELEMENT MIT MAGNETISCHEN EIGENSCHAFTEN UND VERFAHREN**
COMPONENT WITH A STRUCTURE ELEMENT HAVING MAGNETIC PROPERTIES AND METHOD
COMPOSANT COMPORTANT UN ELEMENT DE STRUCTURE PRESENTANT DES PROPRIETES MAGNETIQUES, ET PROCEDE ASSOCIE

(30) Priorität: 18.07.2003 DE 10332826
(43) Veröffentlichungstag der Anmeldung: 19.04.2006
(73) Patentinhaber: Qimonda AG, 81739 München (DE)
(72) Erfinder: BRANDT, Martin, S., 85748 Garching (DE); GÖNNENWEIN, Sebastian, T., B., NL-JE 2611 Delft (NL); GRAF, Tobias, 85579 Neubiberg (DE); HÜBL, Hans, 80538 München (DE); WASSNER, Thomas, 83313 Siegsdorf (DE)
(74) Vertreter: Fischer, Volker
(86) Internationale Anmeldenummer: PCT/DE2004/001559
(87) Internationale Veröffentlichungsnummer: WO 2005/011010

(56) Entgegenhaltungen:
- DE-A1- 19 706 012
- US-A- 4 664 941
- US-B1- 6 483 672
- WILLIS J O ET AL: "Electronic properties and structure of the plutonium-hydrogen system" PHYSICA B & C NETHERLANDS, Bd. 130B+C, Nr. 1-3, Mai 1985 (1985-05), Seiten 527-529, XP002315492 ISSN: 0378-4363
- CHEVALIER B ET AL: "Ferromagnetic behavior of the new hydride CeNiSnH1.8(2)" CHEMISTRY OF MATERIALS AMERICAN CHEM. SOC USA, Bd. 15, Nr. 11, 3. Juni 2003 (2003-06-03), Seiten 2181-2185, XP002315493 ISSN: 0897-4756
- GOENNENWEIN S T B ET AL: "Hydrogen control of ferromagnetism in a dilute magnetic semiconductor" PHYSICAL REVIEW LETTERS APS USA, Bd. 92, Nr. 22, 4. Juni 2004 (2004-06-04), Seiten 227202/1-4, XP002315494 ISSN: 0031-9007
- OVERBERG M E ET AL: "Hydrogenation effects on magnetic properties of GaMnP" ELECTROCHEMICAL AND SOLID-STATE LETTERS ELECTROCHEM. SOC USA, Bd. 6, Nr. 11, 28. August 2003 (2003-08-28), Seiten G131-G133, XP002315495 ISSN: 1099-0062
- BAIK K H ET AL: "Effects of hydrogen incorporation in GaMnN" APPLIED PHYSICS LETTERS AIP USA, Bd. 83, Nr. 26, 29. Dezember 2003 (2003-12-29), Seiten 5458-5460, XP002315496 ISSN: 0003-6951
- OMELJANOVSKY E M ET AL: "HYDROGEN PASSIVATION OF DONORS AND ACCEPTORS IN INP" SEMICONDUCTOR SCIENCE AND TECHNOLOGY, INSTITUTE OF PHYSICS. LONDON, GB, Bd. 4, Nr. 11, 1. November 1989 (1989-11-01), Seiten 947-950, XP000080436 ISSN: 0268-1242
- STUTZMANN M ET AL: "A COMPARISON OF HYDROGEN INCORPORATION AND EFFUSION IN DOPED CRYSTALLINE SILICON, GERMANIUM, AND GALLIUM ARSENIDE" APPLIED PHYSICS A. SOLIDS AND SURFACES, SPRINGER VERLAG. HEIDELBERG, DE, Bd. A53, Nr. 1, Juli 1991 (1991-07), Seiten 47-53, XP009042317 ISSN: 0721-7250 in der Anmeldung erwähnt

## Beschreibung

Magnetische Halbleiter sind wichtige Komponenten moderner Bauelemente der Magnetoelektronik oder Spintronik, da sie spinpolarisierte Ladungsträger bereitstellen. Wichtige Beispiele für Bauelemente, die auf der Ausnutzung von Spinfreiheitsgraden beruhen, sind magnetische Direktzugriffsspeicher (magnetic random access memory, MRAM), Magnetfeldsensoren, Leuchtdioden und Laser, die zirkular-polarisiertes Licht aussenden, Spintransistoren sowie Bauelemente, die zur Realisierung von quantenlogischen Gattern dienen. Bevorzugt wird in solchen Bauelementen der Transport von Ladungsträgern durch die Variation der Magnetisierung einzelner Schichten, durch Variation der spinpolarisierten Zustandsdichte, durch Variatiqn der spinabhängigen Streuung an Grenzflächen oder durch innere oder äußere magnetische oder elektrische Felder, die z.B. mittels Gateelektroden angelegt werden, verändert. Diese Effekte werden summarisch als magnetoresistive Effekte bezeichnet (Abkürzung MR oder XMR). Man unterscheidet u.a. Änderungen des Ladungsträgertransportes aufgrund von spinabhängiger Streuung (giant magnetoresistance, GMR) und aufgrund von Tunnelprozessen zwischen Ferromagneten mit unterschiedlicher spinpolarisierter Zustandsdichte (tunnelling magnetoresistance, TMR). Im Gegensatz zu ferromagnetischen Metallen hat die Verwendung von magnetischen Halbleitern in solchen Bauelementen den besonderen Vorteil, dass die magnetischen Eigenschaften durch Gateelektroden elektrisch schaltbar sein können, siehe z.B. A. Waag et al., Journal of Superconductivity 14, 291 (2001).

In herkömmlichen Halbleitern wie z.B. Si, Ge, GaAs oder ZnSe sind alle Elektronenschalen vollständig gefüllt, die Materialien sind diamagnetisch. Andere magnetische Eigenschaften können durch das Einbringen von speziellen Atomen mit ungesättigten Elektronenschalen erzeugt werden. Bevorzugt werden dazu Atome der Übergangsmetalle oder der seltenen Erden verwendet, da nach der Hundschen Regel hohe Spinzustände in ihren ungesättigten d-Schalen bzw. f-Schalen entstehen. Bei geringen Konzentrationen solcher Atome mit ungesättigten Schalen in Halbleitern ergibt sich ein paramagnetisches Verhalten. Bei höheren Konzentrationen kommt es zu Wechselwirkungen zwischen den magnetischen Momenten, sodass sich ein semimagnetisches Verhalten (gekennzeichnet durch eine hohe magnetische Suszeptibilität, aber ohne die Ausbildung einer spontanen magnetischen Ordnung) oder ein ferromagnetisches Verhalten einstellt.

Bevorzugtes Atom für die Erzeugung von ferromagnetischen Halbleitern ist Mn. In seinem Oxidationszustand 2+ hat Mn einen Elektronenspin von S=5/2. Dies ist der größte Elektronenspin, der nach der Hundschen Regel in Übergansmetallatomen erzeugt werden kann. Mn wird sowohl in Elementhalbleitern wie z.B. Ge, in III-V-Verbindungshalbleitern wie z.B. GaAs sowie auch in II-VI-Verbindungshalbleitern wie z.B. ZnTe zur Erzeugung von Ferromagnetismus verwendet (Y. D. Park et al., Science 295, 651 (2002), T. Dietl et al., Phys. Rev. B 63, 195205 (2001) und D. Ferrand et al., Phys. Rev. B 63, 085201 (2001)).

Für die Erzeugung von Ferromagnetismus ist neben den lokalisierten magnetischen Momenten eine hinreichend starke magnetische Wechselwirkung zwischen ihnen notwendig. In Halbleitern kann diese Wechselwirkung durch elektronische Ladungsträger (Elektronen oder Löcher) vermittelt werden, wenn sie in hinreichender Konzentration ebenfalls in dem Material vorhanden sind. Die genauen magnetischen Eigenschaften der Halbleiter hängen dabei empfindlich von der Konzentration der Ladungsträger ab. Die notwendigen Ladungsträger können auf verschiedene Arten erzeugt werden, z.B. durch die eingebrachten Übergangsmetall- bzw. Seltenerdatome selbst, wenn sie elektronische Zustände in einem Band des Halbleiters haben oder wenn sie Donator- oder Akzeptorzustände in der Nähe der Bandkanten bilden (wie z.B. Mn in GaAs), oder durch Kodotierung mit anderen Atomen, die als Donatoren oder Akzeptoren wirken (wie z.B. N in ZnTe:Mn).

Von herkömmlichen dotierten Halbleitern ist bekannt, dass die elektronischen Auswirkungen von Dotieratomen durch das Einbringen von Wasserstoff beeinflusst werden können. Zum Beispiel lässt sich in vielen Fällen die Dotierung vollständig rückgängig machen; die Ladungsträgerkonzentration nimmt durch Einbringen von Wasserstoff drastisch ab. Dies geschieht in der Mehrzahl der Fälle durch die Ausbildung von Komplexen des Dotieratomes mit Wasserstoff, die elektronisch nicht mehr aktiv sind. Diese Situation bezeichnet man als Passivierung der Donatoren bzw. Akzeptoren. Für Zn-Akzeptoren in GaAs wird dies u.a. in M. Stutzmann et al., Appl. Phys. A 53, 47 (1991) diskutiert.

Wasserstoff kann aber auch isoliert in Halbleitern vorkommen und bildet dann selbst elektronisch aktive Akzeptor- oder Donatorzustände (C. van de Walle et al., Nature 423, 626 (2003)), die zur Bildung von freien Ladungsträgern führen. Diese Akzeptor- oder Donatorzustände des Wasserstoffs können aber auch durch sog. Kompensation anderer Akzeptoren oder Donatoren zu einer Reduktion der Konzentration an freien Ladungsträgern führen.

Mit Halbleitern werden hier auch Materialien bezeichnet, die ohne das Einbringen von Übergangsmetall-, Seltenerd- oder Dotieratomen halbleitend sind, aber durch das Einbringen solcher Atome metallisch leitfähig werden.

DE 197 06 012 A1 zeigt ein Bauelement, nämlich einen magnetischen Messfühler, der sowohl ferromagnetische Schichten als auch nicht-magnetische Zwischenschichten aufweist, wobei nur die nicht-magnetischen Zwischenschichten Wasserstoff enthalten.

US 4,664,941 A zeigt ein Verfahren zum Einbringen von Wasserstoff in ein auf einem Substrat auszubildendes Bauelement mit Hilfe eines Implantationsprozesses.

US 6,483,672 B1 zeigt ein Bauelement, nämlich einen Schreib-Lese-Kopf, mit einem Strukturelement, das magnetische Eigenschaften besitzt, die von einem Wasserstoffgehalt abhängig sind, wobei das Grundmaterial des magnetischen Strukturelements ein metallischer Leiter ist.

In CHEVALIER B. et al.: "Ferromagnetic behavior of the new hydride CeNiSnH1.8(2)", Chemistry of Materials American Chem. Soc. USA, Bd. 15, Nr. 11, 3. Juni 2002 (2003-06-03), Seiten 2181-2185 ist ein Strukturelement aus einem Grundmaterial beschrieben, in welchem Wasserstoff nicht in Form einer Dotierung enthalten ist, sondern gemäß der Summenformel als wesentlicher Bestandteil des Grundmaterials vorliegt.

In WILLIS J.O. et al.: "Electronic properties and structure of the plutonium-hydrogen system", PHYSICA B & C Netherlands, Bd. 130 B+C, Nr. 1-3, Mai 1985 (1985-05), Seiten 527-529 werden Eigenschaften des Materials Plutoniumhydrid beschrieben, welches gemäß der Summenformel Wasserstoff als wesentlichen Bestandteil des Grundmaterials enthält.

Es ist die Aufgabe der vorliegenden Erfindung, die technische Möglichkeiten der Beeinflussung magnetischer Eigenschaften von Materialien, insbesondere von Festkörpern, grundlegend zu erweitern. Es soll insbesondere ein Bauteil mit einem Strukturelement bereitgestellt werden, das ein Grundmaterial enthält, dessen magnetische Eigenschaften gegenüber dem herkömmlich bekannten magnetischen Verhalten desselben Grundmaterials veränderbar sind. Ferner soll ein grundlegendes Verfahren bereitgestellt werden, mit dem die magnetischen Eigenschaften von Materialien, insbesondere von Festkörpern, wesentlich veränderbar sind, mit dem beispielsweise Phasenumwandlungen des magnetischen Zustands eines Materials erzielbar sind.

Diese Aufgabe wird gemäß Anspruch 1 gelöst durch ein Bauteil mit einem Strukturelement, das magnetische Eigenschaften besitzt, die vom Gehalt an Wasserstoff in dem Strukturelement abhängen, wobei das Strukturelement ein Grundmaterial, das ein magnetischer Halbleiter ist, und einen Gehalt an Wasserstoff in Form einer Wasserstoff-Dotierung enthält, wobei das Strukturelement aufgrund des Gehalts an Wasserstoff zumindest in einem ersten Bereich eine verringerte Curietemperatur besitzt.

Erfindungsgemäß wird ein Strukturelement aus einem solchen Material bereitgestellt, das magnetische Eigenschaften besitzt, d.h. nicht lediglich diamagnetisch ist, sondern dessen Diamagnetismus durch mindestens eine andere, stärkere Erscheinungsform des Magnetismus überlagert ist, etwa durch Ferro- oder Antiferromagnetismus, durch Paramagnetismus, Ferrimagnetismus oder durch eine sonstige magnetische Erscheingungsform.

Erfindungsgemäss wird ferner ein solches magnetisches Material für das Strukturelement ausgewählt, dessen magnetische Eigenschaften vom Gehalt an Wasserstoff in diesen Material abhängen. Solche Abhängigkeiten magnetischer Eigenschaften vom Wasserstoffgehalt wurden bislang noch nicht technisch ausgenutzt; die magnetischen Eigenschaften eines Festkörpers werden üblicherweise durch die aufwendige Herstellung und gezielte Zusammenmischung äußerst komplexer metallhaltiger Verbindungen eingestellt. Erfindungsgemäß wurde jedoch festgestellt, dass bei geeigneter Wahl des magnetischen Materials ein geringer Gehalt an Wasserstoff, der in den Festkörper eingebracht wird, das magnetische Verhalten drastisch verändern kann. So sind beispielsweise in einem magnetischen Halbleiter mit begrenzter elektrischer Leitfähigkeit bei Raumtemperatur nicht nur die elektrischen Eigenschaften, sondern auch die magnetischen Eigenschaften durch Einbrigen von Wasserstoff veränderbar.

Erfindungsgemäß wird schliesslich ein geeignetes Grundmaterial mit Wasserstoff versehen. Der Gehalt an Wasserstoff hat zur Folge, dass das magnetische Verhalten des Hauptbestandteils, aus dem das Strukturelement im wesentlichen gebildet ist, ein anderes ist als das herkömmlich bekannte magnetische Verhalten desselben Hauptbestandteils. Dadurch kann durch Einbringen von Wasserstoff ein eigentlich ferromagnetisches Material in ein paramagnetisches Material umgewandelt werden.

Erfindungsgemäß kann der Wasserstoff in jeder Erscheinungsform, etwa in Form atomarer Teilchen, von Radikalen, von Ionen oder von wasserstoffhaltigen Molekülen, die beim Auftreffen auf das Grundmaterial Wasserstoff abspalten, eingebracht werden. Ferner können alle Isotrope des Wasserstoffs, beispielsweise auch Deuterium, zur Veränderung der magnetischen Eigenschaften eingesetzt werden. Ferner kommt erfindungsgemäß insbesondere ein Einbringen von Wasserstoff in zunächst molekularer Form, in ionischer Form oder in Form eines Radikals in Betracht, wobei diese Aufzählung nicht abschließend ist. Entscheidend ist nur, dass in dem Grundmaterial, in das der Wasserstoff eingebracht wird, Wasserstoffteilchen entstehen, die die magnetischen Eigenschaften des Grundmaterials verändern. Eine solche Veränderung kann insbesondere eine magnetische Phasenumwandlung sein, bei der das Vorliegen einer bestimmten magnetische Phase von dem Vorhandensein und von der Konzentration des Wasserstoffs abhängt. Ferner können Übergangsparameter zwischen verschiedenen magnetischen Phasen durch den Wasserstoffgehalt verändert werden. Somit wird erfindungsgemäß erstmals technisch ausgenutzt, dass die Zugabe von Wasserstoff zu einem Material, vorzugsweise eine Festkörper, nicht nur dessen elektrische, sondern auch dessen magnetische Eigenschaften verändert werden.

Gegenstand der Erfindung sind Halbleiter, deren magnetische Eigenschaften mit Hilfe von Wasserstoff verändert sind, Verfahren zur Manipulation der magnetischen Eigenschaften durch Wasserstoff und Bauelemente, in den Halbleiter verwendet werden, deren magnetischen Eigenschaften durch Wasserstoff verändert sind. Mit dieser Erfindung lassen sich eine Vielzahl von Problemen bei der Anwendung semi- oder ferromagnetischer Halbleiterschichten vorteilhaft lösen. Durch das gezielte, ggf. lateral und in der Tiefe der Schichten unterschiedliche Einbringen von Wasserstoff lassen sich die magnetischen Eigenschaften solcher Schichten nach dem Wachstum beeinflussen, z.B. um vorhandene Inhomogenitäten auszugleichen oder um die Filme magnetisch zu strukturieren und magnetoelektronische Bauelemente zu erzeugen. Ein besonderer Vorteil dieser Erfindung ist dabei, dass für die Herstellung von magnetisch/nichtmagnetischen Heterostrukturen nur ein Halbleitermaterial benötigt wird, und somit an den Grenzflächen der Heterostruktur wesentlich geringere Defektdichten auftreten als bei der Verwendung unterschiedlicher Materialien wie z.B. Metallen und Oxiden zur Realisierung entsprechender Heterostrukturen.

Ein Problem ferromagnetischer Materialien, das mit der vorliegenden Erfindung vorteilhaft gelöst wird, ist die laterale Strukturierung ihrer magnetischen Eigenschaften. Diese gelingt herkömmlich durch das Ätzen der Schichten mittels nasschemischer oder ionenunterstützter Verfahren. Jedoch entstehen dabei eine neue Oberflächenstruktur (Oberflächenkorrugation) sowie Defekte in hoher Konzentration und Verspannungen. Durch das Einbringen von Wasserstoff lassen sich hingegen die magnetischen Eigenschaften mit einer hohen lateralen Auflösung strukturieren, ohne eine Änderung der Oberflächentopographie. Damit lassen sich Nanomagneten (z.B. magnetische Quantenpunkte oder -drähte) in einer strukturell homogenen Schicht mit minimalen internen Verspannungen herstellen. Die Oberfläche bleibt glatt, sodass weitere Filme ohne zusätzliche Planarisierungschritte auf der nur magnetisch strukturierten Schicht aufgewachsen werden können.

Ein weiteres Problem ferromagnetischer Halbleiter, das ebenfalls mit der vorliegenden Erfindung vorteilhaft gelöst wird, ist die Tatsache, dass durch das Wachstum der magnetischen Schichten eine magnetische Anisotropie fest vorgegeben wird, die durch das Ätzen von Strukturen nur schwer verändert werden kann. Die magnetische Anisotropie kann aber sehr empfindlich durch eine Einstellung der Konzentration der Ladungsträger kontrolliert werden und lässt sich daher durch geeignete Behandlung mit Wasserstoff auch nach dem Schichtwachstum verändern. Das lateral unterschiedliche Einbringen von Wasserstoff erlaubt dann auch die Realisierung von lateralen Anisotropieübergittern.

Die Erfindung kann darüber hinaus zur Erzeugung weiterer neuartiger magnetischer und magnetisch/nichtmagnetischer Heterostrukturen und Bauelementen verwendet werden. Durch die Ladungsträgerkonzentration kann die Curietemperatur des magnetischen Übergangs verändert werden. Eine inhomogene Verteilung von Wasserstoff kann deshalb ausgenutzt werden, um Bereiche mit unterschiedlichen Curietemperaturen zu erzeugen und somit Heterostrukturen aus unterschiedlichen ferromagnetischen Materialien herzustellen. Wird Wasserstoff mit einem Konzentrationsgradienten eingebracht, so kann ein Material mit Gradienten in seinen magnetischen Eigenschaften hergestellt werden. Wird hinreichend viel Wasserstoff eingebracht, sodass in einem Bereich der Ferromagnetismus ganz zerstört wird, erhält man Heterostrukturen aus ferromagnetischen und nichtmagnetischen Schichten. Durch genaues Einstellen der eingebrachten Wasserstoffkonzentration kann die elektrische Leitfähigkeit der nichtmagnetischen Teile darüber hinaus über einen weiten Bereich eingestellt werden. Insbesondere lässt sich so neben der magnetischen Strukturierung auch eine elektrische Strukturierung erreichen. Benachbarte magnetische Gebiete können so durch halbleitende Bereiche miteinander verbunden oder durch isolierende Bereiche voneinander getrennt werden. Die so gewonnenen Strukturen können im Gegensatz zu entsprechenden Strukturen, wie sie herkömmlich in der Magnetoelektronik oder Spintronik verwendet werden, unter Verwendung nur eines Materialsystems wie z.B. GaAs:Mn hergestellt werden. Die sich daraus ergebenden defektarmen Grenzflächen zwischen den magnetischen und den isolierenden Bereichen wirken sich positiv auf die Eigenschaften dieser Bauelemente aus.

Verschiedene Verfahren sind zur Manipulation der magnetischen Eigenschaften von Halbleitern durch Wasserstoff geeignet. Bevorzugt werden dabei Methoden, bei denen die Halbleiter atomarem Wasserstoff oder Wasserstoffionen ausgesetzt werden. Dies kann bereits während des Wachstums des Halbleiters oder auch nach der Herstellung des Halbleiters geschehen. Molekularer Wasserstoff lässt sich u.a. mittels Gleich- oder Wechselstromplasmen, mittels Kontakt mit heißen Oberflächen oder katalytisch an Metallen wie z.B. Palladium zersetzen. Zum Einbringen von Wasserstoff in einen Halbleiter nach seiner Herstellung wird eine Plasmaentladung bevorzugt, wobei sich der zu behandelnde Halbleiter vorteilhafterweise nicht direkt im Plasma befindet. Besonders bevorzugt wird ein Gleichstromplasma, z.B. bei einer Entladungsspannung von 1000 V und einem Elektrodenabstand von 5 cm. Zur Extraktion von Wasserstoffionen aus dem Plasma wird vorteilhaft eine negative Spannung an die Halterung der Halbleiter angelegt, bevorzugt von über 50 V.

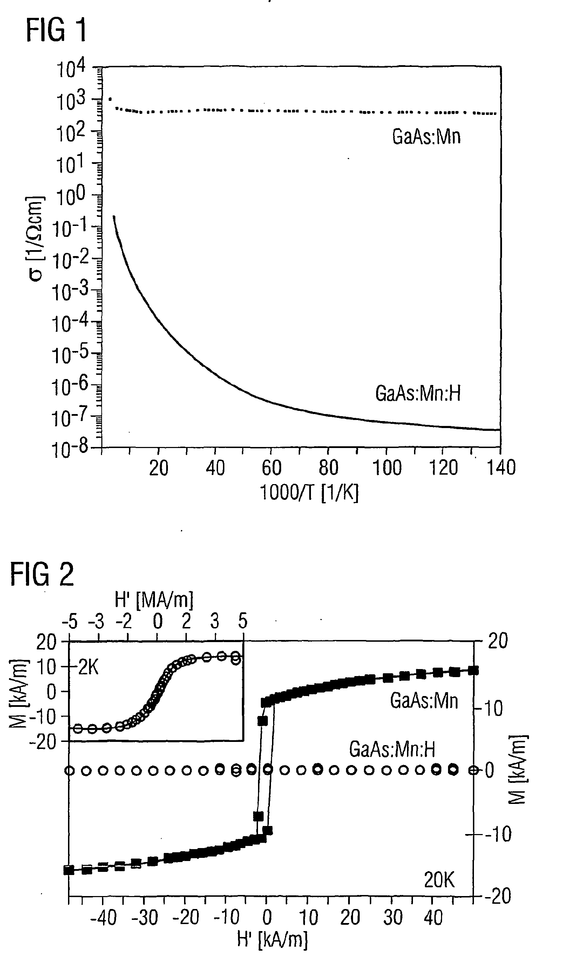

Eine laterale Variation der Konzentration an Wasserstoff, der in das Material eingebracht wird, kann z.B. mit Hilfe von Masken, die entweder eine Diffusion von Wasserstoff lokal verhindern oder zu einer lokalen Dissoziation von Wasserstoff führen (z.B. bei Verwendung von Palladium als Gateelektrode in Abb. 2), oder aber durch die Verwendung fokussierter H-Ionenstrahlen erreicht werden. Eine Variation der Wasserstoffkonzentration in der Tiefe der Schicht kann z.B. durch die Dauer der Behandlung z.B. mit einem Plasma oder durch Implantation von Wasserstoff bei bestimmten Ionenenergien erreicht werden.

Zur Erhöhung der Diffusion von Wasserstoff im Halbleiter und zur Verbesserung der Bildung von Komplexen ist es günstig, den Halbleiter während der Wasserstoffbehandlung zu erwärmen. Für die Passivierung von GaAs:Mn mit Wasserstoff wird bevorzugt eine Temperatur von 100 bis 300°C verwendet, besonders bevorzugt eine Temperatur von 150 bis 200°C.

Neben Wasserstoff kann auch Deuterium für die hier beschriebenen Verfahren, Halbleiter und Bauelemente vorteilhaft verwendet werden, da Komplexe mit Deuterium stabiler sein können als die entsprechenden Komplexe mit Wasserstoff. Daher werden vorstehend alle Isotope des Wasserstoffs zusammenfassend mit Wasserstoff bezeichnet.

Vorzugsweise ist vorgesehen, dass das Strukturelement ein Grundmaterial enthält, das überwiegend aus einem ferromagnetischen Bestandteil gebildet ist, und dass das Grundmaterial aufgrund des Gehalts an Wasserstoff zumindest in einem ersten Bereich paramagnetisch ist. Ein ferromagnetisches Grundmaterial ist beispielsweise mit Mangan dotiertes Galiumarsenid, welches bei Zugabe von Wasserstoff paramagnetisch wird. Infolge der Zugabe von Wasserstoff ändert sich auch die Curie-Temperatur sowie die spontane Magnetisierung des Materials des Strukturelements. Das Grundmaterial des Strukturelements ist vorzugsweise elektrisch isolierend oder halbleitend. Im letzteren Fall lässt sich die elektrische Leitfähigkeit durch den Gehalt an Wasserstoff stark variieren. Insbesondere kann durch eine inhomogene Verteilung des Wasserstoffs die elektrische Leitfähigkeit des Strukturelements räumlich variiert werden.

Der Wasserstoff kann in dem Strukturelement in Form von atomarem oder ionischem Wasserstoff, beispielsweise auch des Deuterium-Isotops, vorliegen. Der Wasserstoff kann ferner in Form von Komplexen mit Atomen von Übergangsmetallen oder von Seltenerdmetallen vorliegen. Der Wasserstoff dient vorzugsweise dazu, einen Teil der in dem Strukturelement vorhandenen freien Ladungsträger zu passivieren und dadurch die magnetischen Eigenschaften des Strukturelements zu verändern. Das Strukturelement kann hinsichtlich seiner äußeren geometrischen Form eine homogene Schicht oder auch eine strukturierte Schicht sein. Es kann auch eine Schicht einer auf einem Substrat angeordneten Schichtenfolge sein. Abgesehen von seiner äußeren räumlichen Gestalt kann das Strukturelement auch noch eine inhomogene magnetische Struktur besitzen, die durch die räumlich variierende Konzentration an Wasserstoff entsteht und nicht ohne weiteres von außen erkennbar ist. Insbesondere kann das gesamte Strukturelement aus einem einheitlichen Grundmaterial ausgebildet sein, welches nur in ersten Bereichen mit Wasserstoff versehen ist. In den ersten Bereichen sind daher die magnetischen Eigenschaften verändert.

Der Wasserstoff in dem Strukturelement kann in lateraler Richtung parallel zu einer Hauptfläche des Strukturelements inhomogen verteilt sein. Der Wasserstoffgehalt kann ebenso in vertikaler Richtung senkrecht zur Hauptfläche des Strukturelements inhomogen sein, beispielsweise senkrecht zu einer Hauptfläche des Strukturelements. Auch kann der Wasserstoff auf einen kleinen Tiefenbereich innerhalb der Tiefenerstreckung des Strukturelements konzentriert und begrenzt sein.

Vorzugsweise ist vorgesehen, dass der Wasserstoff überwiegend in einem ersten Bereich des Strukturelements angeordnet ist und dass das Strukturelement ferner einen zweiten Bereich aufweist, dessen Gehalt an Wasserstoff geringer ist als der Gehalt an Wasserstoff in dem ersten Bereich. Vorzugsweise ist der zweite Bereich des Strukturelements frei von Wasserstoff. In dem ersten Bereich ist hingegen Wasserstoff vorhanden. Der Gehalt an Wasserstoff ist erfindungsgemäß ein gezielt eingebrachter Wasserstoffgehalt, der mit Hilfe eines kontrollierten Einbringungsvorgangs eingebracht wurde, um die magnetischen Eigenschaften des Materials des Strukturelements zu verändern. Unbeabsichtigt oder unvermeidlich auftretende Verunreinigungen des magnetischen Materials, die durch geringste Spuren von Wasserstoff ohne nennenswerten technischen Effekt hinsichtlich der magnetischen Eigenschaften bleiben und nur als Spuren von Verunreinigungen vorhanden sind, sind daher nicht als gezielt eingebrachter Gehalt an Wasserstoff im Sinne der vorliegenden Erfindung zu betrachten.

Der erste Bereich und der zweite Bereich können jeweils Schichten oder Schichtbereiche einer Heterostruktur sein. Vorzugsweise grenzt der zweite Bereich an dem ersten Bereich an. Der erste Bereich kann insbesondere zwischen zwei zweiten Bereichen geringeren oder verschwindenden Wasserstoffgehalts angeordnet sein. Vorzugsweise ist der zweite Bereich ferromagnetisch und der erste Bereich aufgrund des Gehalts an Wasserstoff paramagnetisch.

Eine besonderes vorbezugte Ausführungsform sieht vor, dass der erste Bereich und der zweite Bereich dasselbe Grundmaterial enthalten und dass der erste Bereich zusätzlich Wasserstoff enthält. Der zweite Bereich ist hingegen praktisch frei von Wasserstoff. Einer von mehreren zweiten Bereichen kann an eine Schicht aus einem anderen Grundmaterial als dem Grundmaterial des Strukturelements angrenzen, beispielsweise an eine ferromagnetische Schicht aus beispielsweise Eisen. Dieser zweite Bereich bildet zusammen mit der Schicht aus dem anderen Grundmaterial eine Heterostruktur, die insgesamt ein anderes magnetisches Verhalten, beispielsweise eine andere Koerzitivfeldstärke besitzt als ein andere zweite Bereich.

Der erste Bereich des Strukturelements kann an eine Endfläche, beispielsweise an eine Außenfläche des Strukturelements angrenzen und von dort in das Strukturelement hineinreichen; die Äußenfläche oder Endfläche kann im fertigen Bauteil eine Grenzfläche zu einem anderen Material oder einem anderen Strukturelement sein. Bei dieser Ausführungsform ist vorteilhaft, dass der Wasserstoff nicht durch einem von Wasserstoff freizuhaltenden Bereich hindurch implantiert werden muss, sondern beispielsweise durch Kontakt der Außenfläche mit einem wasserstoffhaltigen Plasma mit Wasserstoff gebildet werden kann.

Die Außenfläche ist vorzugsweise eine Hauptfläche des Strukturelements. Das Strukturelement kann über einem ersten Teil seiner parallel zur Hauptfläche verlaufenden Grundfläche frei von Wasserstoff sein. Über einem zweiten Teil der Grundfläche kann sich von der Hauptfläche aus ein erster, wasserstoffhaltiger Bereich bis in eine erste Tiefe in das Strukturelement hinein erstrecken. Über einem dritten Teil der Grundfläche kann sich von der Hauptfläche aus ein erster, wasserstoffhaltiger Bereich bis in eine erste Tiefe in das Strukturelement hinein erstrecken. Über einem dritten Teil der Grundfläche kann sich der erste, wasserstoffhaltige Bereich von der Hauptfläche aus bis in eine andere, zweite Tiefe in das Strukturelement hinein erstrecken. Somit wird ein erster Bereich, der Wasserstoff enthält, vorgesehen, der über unterschiedlichen Teilen der Grundfläche des Strukturelements eine jeweils unterschiedliche Schichtdicke besitzt. Die restlichen, nicht oder kaum wasserstoffhaltigen zweiten Bereiche des Strukturlements befinden sich zwischen den ersten, wasserstoffhaltigen Bereichen und der Grundfläche des Strukturelements. In ihnen können magnetische Eigenschaften, etwa die Curie-Temperatur oder die Vorzugsrichtung des magnetischen Moments, abhängig sein von der jeweiligen Schichtdicke des zweiten Bereichs zwischen der Grundfläche des Strukturelements und dem ersten, wasserstoffhaltigen Bereich, der sich von der Hauptfläche aus in das Strukturelement hinein erstreckt.

Die der Erfindung zugrundeliegende Aufgabe wird ferner gemäß Anspruch 26 durch ein Verfahren zum Verändern magnetischer Eigenschaften eines Materials gelöst, wobei das Verfahren die folgende Reihenfolge von Schritten aufweist:
- Bereitstellen eines Grundmaterials, welches ein magnetischer Halbleiter ist und magnetische Eigenschaften besitzt, die sich bei Einbringen von Wasserstoff in das Grundmaterial verändern, und
- Einbringen einer Dotierung von Wasserstoff in das Grundmaterial, wodurch die magnetischen Eigenschaften des Grundmaterials zumindest in einem ersten Bereich des Grundmaterials verändert werden,
wobei das Grundmaterial aufgrund des Gehalts an Wasserstoff zumindest in einem ersten Bereich eine verringerte Curietemperatur besitzt.

Der Wasserstoff kann durch Implantation in das Grundmaterial des Strukturelements eingebracht werden, beispielsweise ausschließlich innerhalb eines begrenzten Tiefenbereichs innerhalb der Tiefenerstreckung des Strukturelements. Alternativ kann der Wasserstoff in das Strukturelement eingebracht werden, indem zumindest eine Endfläche oder Außenfläche des Strukturelements mit einem wasserstoffhaltigen Plasma in Kontakt gebracht wird. Bei allen Ausführungsarten der vorliegenden Anmeldungen, bei denen ein Teil des Strukturelements mit einem wasserstoffhaltigen Plasma in Kontakt gebracht wird, ist ebenso denkbar, dass der Wasserstoff auch auf andere Weise durch die entsprechende Außenfläche oder Endfläche des Strukturelements hindurch in das Strukturelement eingebracht, und zwar vorzugsweise derart, dass sich der erste Bereich, der dauerhaft Wasserstoff enthält, bis hin zur Außenfläche oder Endfläches des Strukturelements erstreckt.

Eine erste Teilfläche einer Fläche (Haupt- oder Endfläche) des Strukturelements kann vor einem Kontakt mit dem wasserstoffhaltigen Plasma geschützt werden, beispielsweise mit Hilfe einer Maske. Eine zweite Teilfläche derselben Fläche des Strukturelements kann während einer ersten Zeitdauer dem wasserstoffhaltigen Plasma ausgesetzt werden. Ein dritte Teilfläche derseben Fläche des Strukturelements kann während einer anderen, verschieden langen Zeitdauer dem wasserstoffhaltigen Plasma ausgesetzt werden, um einen ersten Bereich mit einer anderen, beispielsweise kleineren Schichtdicke unterhalb der dritten Teilfläche der Hauptfläche des Strukturelements auszubilden. Außer mit lithographischen und maskentechnischen Verfahren ist das Strukturelement hinsichtlich seiner magnetischen Eigenschaften auch mit Hilfe einen Ionenstrahlschreibers, der wasserstoffhaltige Teilchen freisetzt, strukturierbar.

Der Wasserstoff wird vorzugsweise so in das Strukturelement eingebracht, dass der Wasserstoffgehalt in zumindest einer Richtung innerhalb des Strukturelements inhomogen ist. Dadurch wird in dem Strukturelement eine magnetisch inhomogene Struktur erzeugt. Die räumlich inhomogene Struktur der magnetischen Eigenschaften des Strukturelements variiert über räumliche Distanzen, die die gleiche Größenordnung besitzen wie herkömmlich die geometrischen Abmessungen lithographisch erzeugter Strukturen.

Vorzugsweise wird zunächst das ganze Strukturelement aus einem einheitlichen Grundmaterial, das magnetische Eigenschaften besitzt, hergestellt. Später werden dann die magnetischen Eigenschaften des Grundmaterials nachträglich durch das Einbringen von Wasserstoff in zumindest einem ersten Bereich des Strukturelements verändert. Insbesondere wird dadurch ein ursprünglich ferromagnetisches Grundmaterial in den ersten Bereichen paramagnetisch umgewandelt. Beispielsweise kann mit Mangan dotiertes Galiumarsenid durch Einbringen von Wasserstoff paramagnetisch gemacht werden.

Vorzugsweise ist vorgesehen, dass der erste Bereich und der zweite Bereich des Strukturelements gemeinsam ein monolithisches Material, etwa eine monolithische, epitaktische Schicht bilden, die frei von Grenzflächen oder Grenzflächenzuständen zwischen dem ersten, wasserstoffhaltigen Bereich und dem zweiten Bereich ist. Dadurch kann das Material des Strukturelements als ganzes epitaktisch aufgewachsen werden, was den Herstellungsprozess wesentlich vereinfacht. Diejenigen Bereiche des Strukturelements, deren magnetisches Verhalten nachträglich geändert werden soll, können anschließend mit Wasserstoff versehen werden.

Das Bauteil kann einen Spin-Valve-Transistor, einen Magnetfeldsensor, eine magnetische Speicherzelle oder eine integrierte Halbleiterschaltung aufweisen. Weitere denkbare Anwendungen sind beispielsweise Laser oder Leuchtdioden. Das Bauteil kann insbesondere ein mikroelektronisches Bauelement sein oder ein solches aufweisen.

Eine bevorzugte Realisierung der Erfindung sind magnetische Halbleiter, in denen durch Wasserstoff der Semi- oder Ferromagnetismus reduziert oder gänzlich unterdrückt wird. Durch Bildung von Komplexen oder durch Kompensation wird die Konzentration der Ladungsträger, die die magnetische Wechselwirkung in dem Halbleiter vermitteln, durch Wasserstoff reduziert. Dies führt zu einer Erniedrigung der Übergangs- oder Curietemperatur T_{c} bzw. der spontanen Magnetisierung bis hin zu einer vollständigen Aufhebung des Ferromagnetismus.

Als magnetische Halbleiter werden hier vor allem Materialien bezeichnet, die, wenn sie nicht durch Übergangsmetallatome oder Seltenerdatome dotiert sind, halbleitend sind. Solche Materialien sind beispielsweise C, Si, Ge, GaAs, InAs, GaSb ZnSe, ZnS oder ZnTe. Wird ein solcher Halbleiter degeneriert dotiert, d.h. werden hohe Dotierstoffkonzentrationen von beispielsweise Übergangsmetallatomen oder Seltenerdatomen in diese Halbleiter eingebracht, so können die damit dotierten Materialien bei tiefen Temperaturen noch eine endliche Leitfähigkeit besitzen, die eigentlich für Metalle charakteristisch ist. Ungeachtet dessen werden solche Materialien in der Fachsprache als magnetische bzw. ferromagnetische Halbleiter bezeichnet.

Ein bevorzugter Halbleiter, dessen magnetische Eigenschaften auf diese Weise verändert werden können, ist GaAs:Mn. Besonders bevorzugt ist dabei GaAs, das eine Mn- Konzentration zwischen 0.5 und 10 % der Ga-Atome hat. GaAs:Mn wird vorteilhafterweise mit Hilfe von Molekülstrahlepitaxie hergestellt, bei Substrattemperaturen von 100 bis 600°C, bevorzugt bei Substrattemperaturen von 220 bis 280°C. Einbringen von Wasserstoff in GaAs:Mn in der gleichen Konzentration wie der des Mn führt zu einer starken Reduktion der elektrischen Leitfähigkeit in GaAs:Mn:H, wie in (s. spätere Beschreibung der Abb. 1) in einem Arrheniusdiagramm als Funktion der Temperatur T dargestellt ist. Gleichzeitig verschwindet das typische ferromagnetische Verhalten in Messungen der Magnetisierung M als Funktion des von außen angelegten magnetischen Feldes H; GaAs:Mn:H ist paramagnetisch nach Einbringen des Wasserstoffs, wie in (s. spätere Beschreibung der Abb. 2) dargestellt.

In allen magnetischen Halbleitern, in denen der Magnetismus durch Ladungsträger vermittelt wird, und in denen die Ladungsträgerkonzentration durch Komplexbildung oder Kompensation reduziert werden, kann der Ferromagnetismus durch das Einbringen von Wasserstoff entsprechend reduziert oder ganz unterdrückt werden. Dies gilt insbesondere auch für Halbleiter, in denen die für die magnetische Wechselwirkung notwendigen Ladungsträger durch Kodotierung bereitgestellt werden müssen wie z.B. in Mn-dotierten II-VI-Verbindungshalbleitern. Da die lokalen magnetischen Momente der Übergangsmetall- oder Seltenerdatome durch den Wasserstoff i.A. unverändert bleiben, sind Halbleiter, in denen der Wasserstoff den Ferromagnetismus ganz unterdrückt, i.A. paramagnetisch. Eine schwache verbleibende Wechselwirkung zwischen den magnetischen Momenten kann ggf. auch zu einem Antiferromagnetismus oder Ferrimagnetismus in diesen Halbleitern führen.

Die Erfindung wird nachstehend mit Bezug auf die Figuren 1 bis 11 beschrieben. Es zeigen:
Figur 1 ein Arrhenius-Diagramm für ein wasserstoffhaltiges magnetisches Material,
Figur 2 ein Diagramm für das magnetische Verhalten des Materials aus Figur 1 mit und ohne Wasserstoffgehalt,
Figur 3 eine schematische Darstellung eines Bauteils,
Figur 4 eine erste Ausführungsform eines erfindungsgemäßen Bauteils mit einem Strukturelement,
Figur 5 eine schematische Darstellung des Strukturelements gemäß Figur 4 mit weiteren Angaben zum inneren Aufbau des Strukturelements,
Figur 6 eine zweite Ausführungsform eines erfindungsgemäßen Bauteils mit einem Strukturelement,
Figur 7 ein zur Erfindung alternatives Bauteil mit einem Strukturelement,
Figur 8 eine Weiterbildung eines erfindungsgemäßen Bauteils mit einem Strukturelement in Querschnittansicht,
Figur 9 eine Draufsicht auf das Strukturelement gemäß Figur 8,
Figur 10 eine dritte Ausführungsform eines erfindungsgemäßen Bauteils mit einem Strukturelement und
Figur 11 einen Verfahrensschritt bei der Herstellung des erfindungsgemäßen Bauteils gemäß Figur 10 und
Figur 12 ein weiteres zur Erfindung alternatives Bauteil ähnlich wie in Figur 7.

Figur 1 zeigt ein Arrhenius-Diagramm, in dem die elektrische Leitfähigkeit σ in Abhängigkeit von der reziproken Temperatur dargestellt ist. Die Leitfähigkeit ist für mit Mangan dotiertes Galliumarsenid aufgetragen, und zwar mit (durchgezogene Linie) und ohne (gepunktete Linie) zusätzlichem Wasserstoffgehalt in dem dotierten Galliumarsenid. Es ist erkennbar, dass die Zugabe von Wasserstoff die elektrische Leitfähigkeit deutlich absenkt.

Figur 2 zeigt die Abhängigkeit der Magnetisierung M für mit Mangan dotiertes Galliumarsenid in Abhängigkeit von einem äußeren Magnetfeld H'. Während für das wasserstofffreie Grundmaterial bei 20 Kelvin die für den Ferromagnetismus typische Hysteresekurve erkennbar ist (schwarze quadratische Messpunkte), bricht bei Zugabe von Wasserstoff die starke ferromagnetische Magnetisierung zusammen (weiße kreisförmige Messpunkte). Das für eine Temperatur von 2 Kelvin dargestellte Teildiagramm zeigt die Magnetisierung des wasserstoffhaltigen Materials, gemessen bei stärkeren Magnetfeldern. Es ist das typisch paramagnetische Verhalten erkennbar, welches insbesondere bei sehr tiefen Temperaturen experimentell leichter zu beobachten ist.

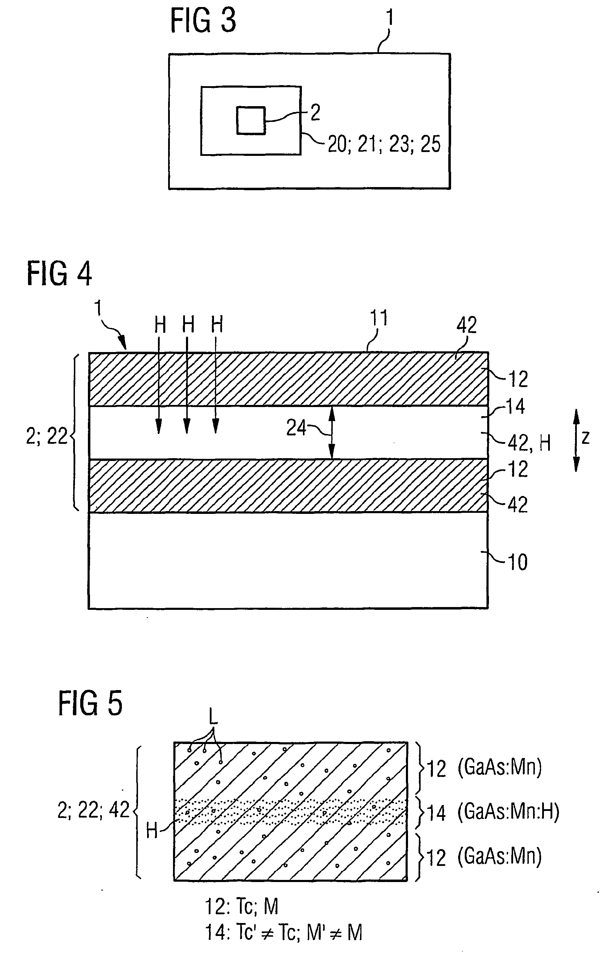

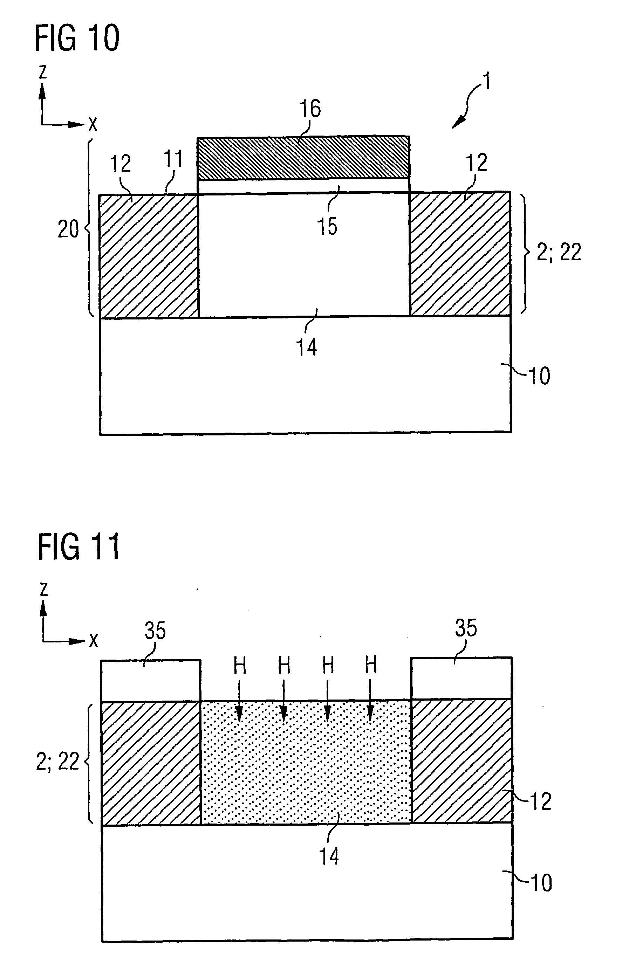

Zwei mögliche Realisierungen von Bauelementen, bei denen die magnetischen Eigenschaften eines Strukturelements aufgrund des eingebrachten Wasserstoffs inhomogen sind, sind in Figuren 4 und 10 schematisch wiedergegeben. Figur 4 zeigt eine vertikale Heterostruktur, Figur 10 eine laterale Heterostruktur aus magnetischen und nichtmagnetischen Halbleitern. Auf dem Substrat 10 in Figur 4 befinden sich Schichten eines oder unterschiedlicher magnetischer Halbleiter 12. Dazwischen befindet sich eine Halbleiterschicht 14, in der durch das Einbringen von Wasserstoff der Ferromagnetismus zerstört wurde. Bevorzugt werden die abgebildeten Strukturen durch in der Tiefe inhomogenes Einbringen von Wasserstoff in eine vorher homogene ferromagnetische Halbleiterschicht erzeugt. Eine in lateraler Richtung inhomogene Gestaltung der magnetischen Eigenschaften wird noch mit Bezug auf die Figur 10 erläutert werden.

Elektronische Transportprozesse durch diese Strukturen können durch eine Variation der Magnetisierung einzelner Schichten, durch eine Variation der spinpolarisierten Zustandsdichte einzelner Schichten, durch eine Variation der spinabhängigen Streuung an Grenzflächen zwischen den Schichten, durch eine Variation der Leitfähigkeit der Schichten oder durch eine Variation der inneren oder äußeren magnetischen oder elektrischen Felder beeinflusst werden. Solche Strukturen lassen sich vorteilhaft z.B. als Sensoren für magnetische Felder oder als magnetische Direktzugriffsspeicher verwenden.

Diese Strukturen können nach Bedarf z.B. durch Kontaktschichten und Zuleitungen, durch geeignete isolierende Zwischenschichten zur Vermeidung von elektronischem Transport durch das Substrat, durch magnetisch harte Schichten zur Festlegung von magnetischen Vorzugsorientierungen und durch andere Halbleiterstrukturen oder Bauelementen erweitert werden. Die Schichten 12 und 14 selbst können aus einer Kombinationen unterschiedlicher Halbleiter bestehen oder inhomogene Dotierungen oder inhomogene magnetische Eigenschaften besitzen. Heterostrukturen aus magnetischen und nichtmagnetischen Schichten lassen sich erfindungsgemäß auch aus Kombinationen von ferromagnetischen Metallen und Halbleitern, in denen wie hier beschrieben der Ferromagnetismus durch Wasserstoff zerstört wurde, oder aus Kombinationen von Halbleitern, in denen wie hier beschrieben Ferromagnetismus durch Wasserstoff erzeugt wird, und nichtmagnetischen Materialien herstellen.

Eine besonders bevorzugte Realisierung ist ein Bauelement nach Abb. 4, bei dem die ferromagnetischen Halbleiterschichten 12 aus GaAs:Mn bestehen, mit einer Mn-Konzentration von 0.5 bis 10%. Diese Schichten sind jeweils zwischen 1 und 100 nm dick, bevorzugt zwischen 20 und 100 nm. Zwischen diesen beiden Schichten befindet sich eine Schicht GaAs:Mn 14, in die Wasserstoff eingebracht wurde, sodass diese Schicht nicht mehr ferromagnetisch ist. Diese Schicht 14 ist zwischen 0.5 und 10 nm dick, bevorzugt zwischen 1 und 5 nm. Bevorzugt wird diese Schichtstruktur aus einer dicken Schicht GaAs:Mn hergestellt, in die in der gewünschten Tiefe Wasserstoff eingebracht wird. Dies geschieht z.B. durch Ionenimplantation. Bevorzugt wird zur Herstellung einer isolierenden Schicht GaAs:Mn:H mit einer Dicke von etwa 3 nm und in einer Tiefe von etwa 50 nm in GaAs:Mn mit 5% Mn eine Implantation mit Wasserstoff bei einer Beschleunigungsspannung der Wasserstoffionen von 5 keV und einer Beladung mit Wasserstoffionen von 3x10¹⁴ pro cm² verwendet. Nach der Implantation kann eine Temperung der Schichtstruktur, bevorzugt bei Temperaturen zwischen 100 und 300°C, angeschlossen werden.

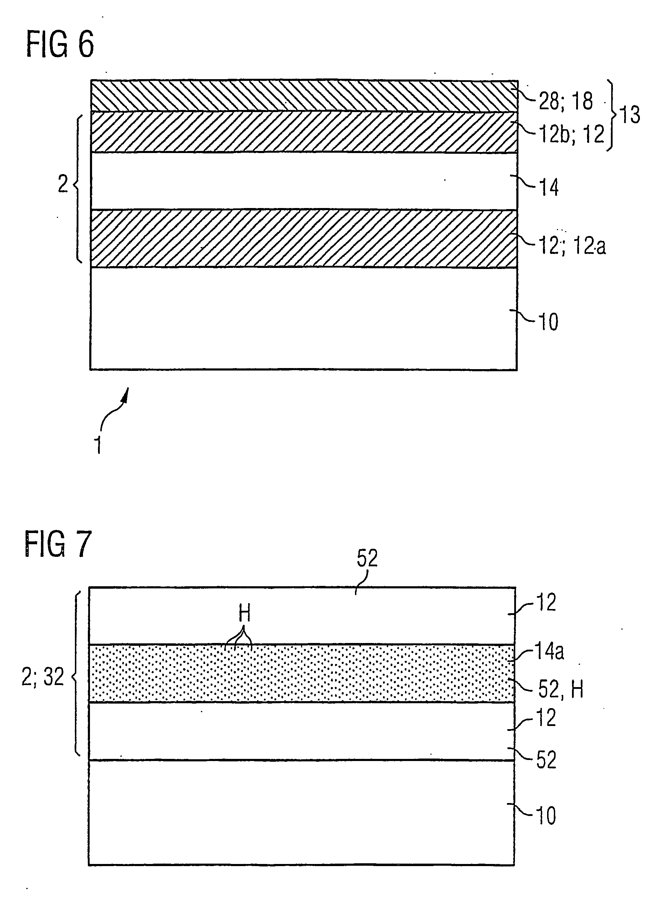

Um ein Schalten der beiden ferromagnetischen Schichten 12 bei unterschiedlichen Koerzitivfeldstärken zu gewährleisten, können ihre Schichtdicken unterschiedlich gewählt werden. Alternativ können unterschiedliche Koerzitivfeldstärken auch durch eine Variation der Mn-Konzentration in den beiden Schichten realisiert werden, bevorzugt durch einen Unterschied der Konzentrationen von wenigstens 1%. Besonders bevorzugt werden unterschiedliche Koerzitivfeldstärken durch Einbringen von Wasserstoff in eine der beiden Schichten 12 realisiert, durch Implantation oder Behandlung in einem Wasserstoffplasma. Bevorzugt wird bei dieser Behandlung ein Unterschied der Koerzitivfeldstärken in den beiden Schichten 12 von wenigstens 1 kA/m realisiert, oder wenigstens in einer der beiden Schichten 12 ein Prozent Wasserstoff bezogen auf die Konzentration der Ga-Atome in GaAs:Mn eingebracht, gemittelt über die jeweilige Schicht. Alternativ lassen sich unterschiedliche Koerzitivfeldstärken der Schichten auch durch Verwendung von Heterostrukturen herstellen, wie in Abb. 6 dargestellt. Dabei wird die obere ferromagnetische Schicht durch eine Schichtstruktur aus einer ferromagnetischen Halbleiterschicht 12 und einer weiteren ferromagnetischen Schicht 18 ersetzt. Diese Schicht besteht bevorzugt aus GaAs:Mn mit einer Dicke von 50 nm, die Schicht aus Eisen mit einer bevorzugten Dicke von 10 nm.

Ist die Schicht 14 in den obigen Strukturen isolierend, so wird die Leitfähigkeit zwischen den Schichten 12 wegen des Tunnelmagnetowiderstandes abhängig sein von der relativen Orientierung der Magnetisierungen in den Schichten 12. Ist die Schicht 14 metallisch leitfähig, aber nicht ferromagnetisch, so wird der Widerstand der gesamten Schichtstruktur wegen des Riesenmagnetwiderstandes abhängig sein von der relativen Orientierung der Magnetisierungen in den Schichten 12. Beide Strukturen können zur Messung von Magnetfeldern oder in magnetischen Direktzugriffsspeichern verwendet werden.

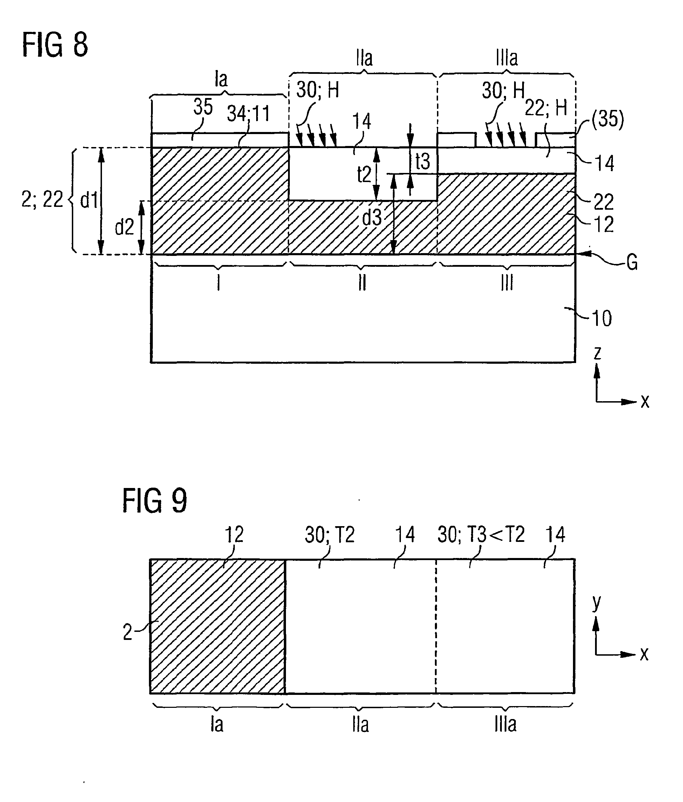

Eine weitere besonders bevorzugte Realisierung ist eine laterale Heterostruktur in der durch Einbringen von Wasserstoff die magnetischen Eigenschaften einer zunächst magnetisch homogenen Schicht verändert worden sind. Eine besonders bevorzugte Realisierung ist eine Heterostruktur, bei der Wasserstoff nur in einige Bereiche der Schicht eingebracht ist. Die Heterostruktur kann auch Bereiche enthalten, in denen Wasserstoff unterschiedlich tief und/oder in unterschiedlicher Konzentration eingebracht ist. Dies kann z.B. dadurch erreicht werden, dass Teile der Schicht unterschiedlich lang dem oben beschriebenen dc-Plasmas ausgesetzt werden, wobei die laterale Strukturierung durch Verwendung von Masken erreicht werden kann. Bevorzugte Masken, die eine Eindiffusion von Wasserstoff verhindern, sind dünne Filme aus Gold (Dicke bevorzugt 5-1000 nm) oder SiO₂ bzw. Si₃N₄ (Dicke bevorzugt 50-5000 nm). Besonders bevorzugt werden laterale Heterostrukturen, bei denen der Wasserstoff so eindiffundiert ist, dass sich an der Oberfläche der ursprünglich ferromagnetischen Schicht 12 lokal eine nicht-ferromagnetische Schicht 14 bildet, die unterschiedlich dick sein kann. Solch eine Ausführungsform wird noch mit Bezug auf die Figur 8 erläutert werden. Bevorzugt werden dabei Dicken der nicht-ferromagnetischen Schichten von wenigstens 1 nm realisiert. Besonders bevorzugt werden laterale Heterostrukturen, bei denen sich durch den Einfluss des Wasserstoffs lokal die Richtung der leichten Magnetisierung verändert.

Figur 3 zeigt schematisch ein erfindungsgemäßes Bauteil 1, das ein Strukturelement 2 aus einem magnetischen Material aufweist, dessen magnetische Eigenschaften erfindungsgemäß durch die Zugabe von Wasserstoff verändert sind. Das Strukturelement 2 kann in einer übergeordneten Einheit enthalten sein, die beispielsweise ein Spin-Valve-Transistor 20, ein Magnetfeldsensor 21, eine magnetische Speicherzelle 23 oder eine integrierte Halbleiterschaltung 25 sein kann. Diese übergeordnete Einheit kann Teil des Bauelements 1 sein. Das Bauelement 1 kann ebenso mit der übergeordneten Einheit identisch sein. Als weitere Ausgestaltungen kommen ferner Laser oder Leuchtdioden in Frage.

Figur 4 zeigt im Querschnitt eine erste Ausführungsform eines erfindungsgemäßen Bauteils 1, das auf einem Substrat 10 ein Strukturelement 2 aus einem Grundmaterial 22 aufweist, das in wasserstofffreiem Zustand ferromagnetisch ist. In einem ersten Bereich 14 enthält das Grundmaterial 22 zusätzlich Wasserstoff H, der nach dem Strukturieren des Strukturelements 2 nachträglich durch Implantation in einen mittleren Tiefenbereich 24 eingebracht wurde, wie durch die Pfeile in Figur 4 dargestellt. Durch das Implantieren des Wasserstoffs in das Strukturelement 2 wurde dieses in einem ersten Bereich 14 paramagnetisch gemacht. In mindestens einem zweiten Bereich 12 hingegen ist das Material des Strukturelements 2 weiterhin ferromagnetisch. Das Strukturelement 2 ist bezüglich seines magnetischen Verhaltens in vertikaler Richtung z senkrecht zu einer Hauptfläche 11 des Strukturelements 2 strukturiert. In den zweiten Bereichen 12 enthält das Grundmaterial 22 des Strukturelements 2 einen ferromagnetischen Bestandteil 42, vorzugsweise GaAs:Mn. In dem ersten Bereich 14 ist dieses Material zusätzlich mit Wasserstoff H dotiert. In dem Ausführungsbeispiel der Figur 4 ist der Wasserstoff vorzugsweise durch Implantation eingebracht. Die Schichtdicken in Figur 4 sind nicht maßstabsgerecht dargestellt. Richtwerte für die Schichtdicken sind etwa der Beschreibung der Figur 6 entnehmbar.

Figur 5 zeigt eine schematische Darstellung des Strukturelements 2 aus Figur 4 mit weiteren Angaben zu dem inneren Aufbau des Grundmaterials 22. Das gesamte Strukturelement 2 enthält ein einheitliches Grundmaterial 22, nämlich beispielsweise GaAs:Mn, so dass innerhalb des Strukturelements keine ausgeprägten Grenzflächen mit einer erhöhten Konzentration von Defekten oder sonstigen störenden Grenzflächenzuständen auftreten.

Aufgrund des einheitlichen Grundmaterials, das durch denselben Verfahrensschritt aufgewachsen wurde, ist insbesondere die Grenze zwischen dem paramagnetischen, ersten Bereich 14 und den ferromagnetischen Bereichen 12 frei von einer erhöhten Konzentration von Defekten oder anderen störenden Grenzflächenzuständen, die zu Störeffekten beim Betrieb des Spin-Transistors führen würden. Erhöhte Defektkonzentrationen sind hingegen bei herkömmlichen Bauteilen an Metall-Isolator-Grenzflächen von Metall-Isolator-Metall-Heterostrukturen unvermeidbar, wenn das Metall und der Isolator durch verschiedene Prozeßschritte hergestellt, etwa abgeschieden oder aufgewachsen werden.

In dem Grundmaterial 22 sind durch große Punkte gekennzeichnete Ladungsträger L angeordnet. In dem ersten Bereich 14 ist zusätzlich Wasserstoff H, der durch kleine Punkte angedeutet ist, eingebracht. Durch den Wasserstoff H wird ein Teil der in dem ersten Bereich 14 angeordneten Ladungsträger L passiviert bzw. neutralisiert und dadurch die elektrische Leitfähigkeit, aber auch das magnetische Verhalten in dem ersten Bereich 14 verändert. Insbesondere ist das Material 22 in dem ersten Bereich 14 nicht mehr ferromagnetisch, sondern paramagnetisch. Dadurch besitzt das Material des Strukturelements 2 in dem ersten Bereich 14 eine andere Curie-Temperatur Tc' und eine andere Magnetisierung M' als in den ferromagnetischen zweiten Bereichen 12. Das Material des Strukturelements kann in dem ersten Bereich 14 auch temperaturunabhängig paramagnetisch sein, d.h. keine Curie-Temperatur mehr besitzen.

Ein Dotierstoffatom, etwa Mangan, entzieht als Akzeptor dem Valenzband des Grundmaterials ein Elektron und erzeugt ein Loch bzw. Defektelektron im Valenzband des Grundmaterials. Bei einer Passivierung von Akzeptoren wird ein Donator, erfindungsgemäß Wasserstoff, in das Grundmaterial eingebracht, dessen in das Leitungsband abgegebenes Elektron mit dem Defektelektron rekombiniert. Wasserstoff kann somit insbesondere als Gegendotierung in ein bereits dotiertes Grundmaterial eingebracht werden (Kompensation). Bei einem weiteren Mechanismus werden Komplexe des Wasserstoffs mit einem anderen Dotierstoff, beispielsweise Mangan, gebildet. In diesem Fall spricht man von einer Passivierung.

Figur 6 zeigt ein erfindungsgemäßes Bauteil 1 gemäß einer zweiten Ausführungsform, bei dem über dem Strukturelement 2 eine Schicht 18 aus einem anderen Grundmaterial 28, beispielsweise Eisen ausgebildet ist. Ferner besitzt einer 12b von mehreren zweiten, ferromagnetischen Bereichen 12a; 12b eine andere Schichtdicke als der andere ferromagnetische Bereich 12a. Zwischen beiden zweiten Bereichen 12a, 12b, die jeweils frei oder weitgehend frei von Wasserstoff sind und gerade deshalb ferromagnetisch sind, ist ein wasserstoffhaltiger Bereich 14 des Strukturelements 2 angeordnet, in dem das Material des Strukturelements 2 paramagnetisch ist. Der eine 12b der beiden zweiten Bereiche bildet gemeinsam mit der Schicht 18 aus dem anderem Grundmaterial 18 eine Heterostruktur 13, die eine andere Koerzitivfeldstärke besitzt als der zwischen dem ersten Bereich 14 und dem Substrat 10 angeordnete zweite Bereich 12a. Die Schichtdicken der Bereiche 12 können in der Größenordnung von 1 bis 100 nm, vorzugsweise 20 bis 100 nm liegen. Die übertrieben dick dargestellte wasserstoffhaltige Galliumarsenidschicht, d.h. der erste Bereich 14, besitzt vorzugsweise eine Schichtdicke zwischen 0,5 und 10 nm und enthält vorzugsweise einen Mangangehalt zwischen 0,5 und 10%.

Figur 7 zeigt ein denkbares, zur Erfindung alternatives Bauteil, bei dem das Strukturelement 2 ein Grundmaterial 32 enthält, das im wesentlichen aus einem paramagnetischen Bestandteil 52 besteht. In einem ersten Bereich 14a ist das Material 32 des Strukturelements 2 aufgrund eines zusätzlichen Gehalts an Wasserstoff H nicht paramagnetisch, sondern ferromagnetisch.

Figur 8 zeigt eine Weiterbildung eines erfindungsgemäßen Bauteils, dessen Strukturelement 2 aus einem vorzugsweise ferromagnetischen Grundmaterial 22 hergestellt ist, dessen magnetische Eigenschaften durch das Einbringen von Wasserstoff in vertikaler Richtung z wie auch in horizontaler Richtung x inhomogen sind. Abgesehen von seiner äußeren geometrischen Struktur besitzt das Strukturelement 2 noch eine innere, magnetische Struktur. Eine Grundfläche G besitzt einen ersten, einen zweiten und einen dritten Teil I, II, III. Auf der entgegengesetzten Seite besitzt das Strukturelement 2 eine Hauptfläche 11, die zugleich eine Endfläche 34 darstellt, die zumindest bereichsweise einem wasserstoffhaltigen Plasma 30 ausgesetzt wird. Eine erste Teilfläche Ia ist gegenüber dem wasserstoffhaltigen Plasma 30 durch eine Maske 35 geschützt, so dass die gesamte Schichtdicke d1 des Strukturelements 2 im Bereich des ersten Teils I der Grundfläche G ferromagnetisch, das heißt als zweiter Bereich 12 ausgebildet ist. Über einem zweiten Teil II der Grundfläche G wurde die Endfläche 34 zeitweise einem wasserstoffhaltigen Plasma 30 ausgesetzt, das durch eine zweite Teilfläche IIa der Endfläche 34 hindurch in das Innere des Strukturelements 2 eingedrungen ist. Dadurch wurde über dem zweiten Bereich II der Grundfläche ein erster, paramagnetischer Bereich 14 des Grundmaterials 22 des Strukturelements 2 ausgebildet, der sich von der Hauptfläche 11 des Strukturelements 2 bis in eine erste Tiefe t2 in das Strukturelement hinein erstreckt. Im Bereich der verbleibenden Schichtdicke d2 ist das Strukturelement 2 weiterhin ferromagnetisch. Über einen dritten Bereich III der Grundfläche G wurde die Endfläche 34 des Strukturelements während einer anderen, vorzugsweise kürzeren Zeitdauer dem wasserstoffhaltigen Plasma 30 ausgesetzt. Dadurch wurde ein paramagnetischer erster Bereich 14 ausgebildet, der sich von der Endfläche 34 aus bis zu einer anderen, in Figur 8 kleineren zweiten Tiefe t3 in das Strukturelement 2 hinein erstreckt. Die verbleibende Schichtdicke d3 unterhalb des ersten Bereichs 14 kennzeichnet den zweiten Bereich 12 über dem dritten Teil III der Grundfläche G des Strukturelements, in dem das Strukturelement weiterhin ferromagnetisch ist.

Fertigungstechnisch lässt sich die geringere Eindringtiefe des Wasserstoffs unterhalb der dritten Teilfläche IIIa der Endfläche 34 (und somit die verringerte Tiefe t3 der Grenze zwischen dem paramagnetischen ersten Bereich 14 und dem ferromagnetischen zweiten Bereich 12) dadurch erreichen, dass die Endfläche 34 des Strukturelements 2 zeitweise dem wasserstoffhaltigen Plasma 30 ausgesetzt wird, andererseits jedoch auch zeitweise mit einer Maske 35 bedeckt wird, wie in Figur 8 durch das in Klammern gesetzte Bezugszeichen 35 und die durch die damit bezeichnete, doppelt schraffiert dargestellte Maske angedeutet. Beispielsweise kann zunächst eine auf den Teilflächen Ia und IIIa angeordnete Maske 35 auf der Endfläche 34 des Strukturelements 2 ausgebildet werden. Dann wird die Endfläche 34 mit dem wasserstoffhaltigen Plasma 30 in Kontakt gebracht, wobei lediglich die zweite Teilfläche IIa der Endfläche 34 dem wasserstoffhaltigen Plasma ausgesetzt wird. Anschließend wird die Maske 35 im Bereich der dritten Teilfläche IIIa entfernt und die Endfläche 34 des Strukturelements erneut dem wasserstoffhaltigen Plasma 30 ausgesetzt. Dabei dringt der Wasserstoff durch die Teilflächen IIa und IIIa in das Strukturelement 2 ein. Durch die längere Zeitdauer, während derer die zweite Teilfläche IIa dem wasserstoffhaltigen Plasma 30 ausgesetzt wurde, ist die erste Tiefe t2 des ersten Bereichs 14 in der Mitte des Strukturelements, d. h. oberhalb des zweiten Teils II der Grundfläche G, größer als die Tiefe t3 des ersten, paramagnetischen Bereichs 14 oberhalb des dritten Teils III der Grundfläche G.

Das in Figur 8 dargestellte Bauteil lässt sich als "Hall-Bar" mit unterschiedlichen Schichtdicken d1, d2, d3 der ferromagnetischen zweiten Bereiche 12 des Strukturelements 2 herstellen, ohne dass das Strukturelement 2 selbst durch eine Ätzung oder andere Schritte, die die geometrische Form des Strukturelements 2 verändern, strukturiert werden muss. Statt dessen erfolgt ausschließlich eine Strukturierung der magnetischen Eigenschaften des Strukturelements, nicht jedoch einer Geometrie. Bei einem ferromagnetischen Grundmaterial 22 hängt die Richtung, in der sich die spontane Magnetisierung am leichtesten ausbildet, unter anderem von der Schichtdicke d1, d2, d3 des ferromagnetischen Bereichs 12 ab. Weitere Einflussfaktoren sind die Ladungskonzentration und anliegnede elektrische Spannungen. Über verschiedenen Teilen I, II, III der Grundfläche G angeordnete Bereiche 12 der ferromagnetischen Hall-Bahn besitzen eine jeweils unterschiedliche Vorzugsrichtung der magnetischen Momente der darin angeordneten beweglichen Ladungsträger. Wird über den Teilen I, II und III der Grundfläche G jeweils eine elektrische Spannung angelegt, deren Spannungsgefälle senkrecht durch die Zeichenebene der Figur 8 verläuft, so lässt sich durch die elektrische Vorspannung die Orientierung des magnetischen Moments verändern. Die unterschiedliche Einstellung der Orientierung der magnetischen Momente kann dazu verwendet werden, den Übergang von Ladungsträgern aus einem ersten Teilvolumen, das zwischen dem Teil I der Grundfläche G und der Teilfläche Ia der Hauptfläche 11 angeordnet ist, in ein weiteres Teilvolumen der Schichtdicke d2 oberhalb des zweiten Teils II der Grundfläche G oder von dort in ein drittes Teilvolumen mit der Schichtdicke d3 über den dritten Teil III der Grundfläche zu bewirken. Dadurch kann ein Schaltelement bereitgestellt werden, bei dem der Übergang der Ladungsträger zwischen verschiedenen Teilvolumina unterschiedlicher Schichtdicke d1, d2, d3 durch eine elektrisch-magnetische Kopplung gesteuert wird. Erfindungsgemäß werden die unterschiedlichen Schichtdicken d1, d2, d3 durch unterschiedliche Eindringtiefen t2, t3 des Wasserstoffs und somit durch eine unterschiedliche Schichtdicke des paramagnetischen, ersten Bereichs 14 oberhalb der ferromagnetischen Teilvolumina hergestellt.

Figur 9 zeigt eine Draufsicht auf das gemäß Figur 8 dargestellte Bauelement. Unterhalb einer ersten Teilfläche Ia der Endfläche 34 ist das Grundmaterial des Strukturelements 2 ferromagnetisch (Bezugszeichen 12). Unterhalb einer zweiten IIa und einer dritten Teilfläche IIIa der in Draufsicht abgebildeten Endfläche hingegen ist ein paramagnetischer erster Bereich 14 angeordnet, der sich unterhalb der zweiten Teilfläche IIa bis in eine Tiefe t2 erstreckt. Er wurde hergestellt, indem die Endfläche während einer Zeitdauer T2 dem wasserstoffhaltigen Plasma 30 ausgesetzt wurde. Die dritte Teilfläche IIIa wurde nur während einer kürzeren Zeitdauer T3 dem Plasma 30 ausgesetzt, so dass die Schichtdicke des paramagnetischen ersten Bereichs 14 im Bereich der Teilfläche II-Ia kleiner ist.

Figur 10 zeigt eine weitere Ausführungsform eines erfindungsgemäßen Bauteils 1, bei dem auf einem Substrat 10 ein Strukturelement 2, das aus einem Grundmaterial 22 mit einem ferromagnetischen Hauptbestandteil besteht, in lateraler Richtung x strukturiert ist. Diese "Strukturierung" ist keine geometrische Strukturierung der geometrischen Abmessungen des Strukturelements, sondern eine räumliche Strukturierung der magnetischen Eigenschaften des Strukturelements 2, etwa in lateraler Richtung x. Insbesondere ist in einem ersten Bereich 14, der beidseitig von zweiten Bereichen 12 umgeben ist, Wasserstoff eingebracht, wodurch das Grundmaterial 22 des Strukturelements 2 in dem ersten Bereich 14 paramagnetisch geworden ist. Anschließend wird auf den ersten Bereich 14 ein Gate-Dielektrikum 15 abgeschieden und darauf die Gate-Elektrode 16 ausgebildet. Das in Figur 10 dargestellte Bauelement 1 enthält einen Spin-Valve-Transistor, dessen zweite Bereiche 12 als Source/Drain-Bereiche dienen, die jeweils ferromagnetisch sind. Der erste Bereich 14, der halbleitend und paramagnetisch ist, enthält zusätzlich zu dem Grundmaterial, beispielsweise mit Mangan dotierten Galliumarsenid, Wasserstoff. Das gesamte Strukturelement 2 wurde durch einen einzigen Epitaxieschritt aufgebracht und erst anschließend magnetisch strukturiert. Dadurch ist die Grenze zwischen dem paramagnetischen, ersten Bereich 14 und den ferromagnetischen zweiten Bereichen 12 frei von einer erhöhten Konzentration von Defekten oder anderen störenden Grenzflächenzuständen, die zu Störeffekten beim Betrieb des Spin-Transistors führen würden. Von dem in Figur 10 beispielsweise links angeordneten ersten Bereich aus können Ladungsträger, die bereits eine bestimmte Vorzugsrichtung ihrer Spins besitzen, in das halbleitende Material in dem ersten Bereich 14, der als Kanalbereich dient, eindringen. Während des Ladungstransports innerhalb des ersten Bereichs präzedieren die Spins mit einer Geschwindigkeit, die von der Gate-Spannung an der Gate-Elektrode 16 abhängt. An der Grenze zwischen dem ersten Bereich 14 und dem in Figur 10 rechts angeordneten zweiten Bereich 12, der ferromagnetisch ist, können beispielsweise nur solche Ladungsträger eindringen, deren Spins eine vorgegebene Vorzugsrichtung besitzen, beispielsweise die nach rechts deuten, wohingegen Ladungsträger mit nach links deutenden Spin nicht in den in Figur 10 rechts angeordneten zweiten Bereich 12 eindringen können. Indem die Orientierung der Spins der den ersten Bereich 14 durchlaufenden Ladungsträger mit Hilfe der Gate-Spannung gesteuert wird, lässt sich der Transistor schalten. Somit wird je nach Beeinflussung des Spins der Elektronen deren Ladungstransport zwischen beiden Source/Drain-Gebieten gefördert oder blockiert. Durch die erfindungsgemäße Einbringung von Wasserstoff in ein bereits vorhandenes Strukturelement 2 auf einem einheitlichen Grundmaterial 22 wird der oben beschriebene Spin-Transistor erstmals fertigungstechnisch realisierbar, da im Falle eines Spin-Transistors, dessen ferromagnetische 12 und paramagnetische Bereiche 14 durch unterschiedliche Epitaxieschritte aufzubringen wären, durch Grenzflächen voneinander getrennt wären, so dass in Folge von Grenzflächenstörstellen eine Vorzugsrichtung der Ladungsträger-Spins beim Durchtritt durch die Grenzfläche zerstört würde.

Strukturen wie in Figur 10 dargestellt lassen sich vorteilhaft z.B. als Sensoren für magnetische Felder oder als magnetische Direktzugriffsspeicher verwenden. Die laterale Struktur in Abb. 10 kann darüber hinaus z.B. durch Verwendung eines elektrischen Gates 16 zu einem spin-valve Transistor erweitert werden.

Figur 11 zeigt einen Verfahrensschritt bei der Herstellung des erfindungsgemäßen Bauteils gemäß Figur 10. In einen mittleren Bereich des Grundmaterials 22 des bereits ausgebildeten Strukturelements 2 wird Wasserstoff H eingebracht, vorzugsweise dadurch, dass das Strukturelement 2 einem Wasserstoffplasma ausgesetzt wird, wie mit Hilfe der Pfeile angedeutet. Alternativ ist auch beispielsweise eine Implantation denkbar. Dadurch wird das ursprünglich ferromagnetische Grundmaterial 22 des Strukturelements 2 in dem mittleren Bereich, der nicht durch eine Maske 35 geschützt ist, paramagnetisch. Nach dem Einbringen des Wasserstoffs wird ein Gate-Dielektrikum 15 aufgebracht und darauf die Gate-Elektrode 16 ausgebildet.

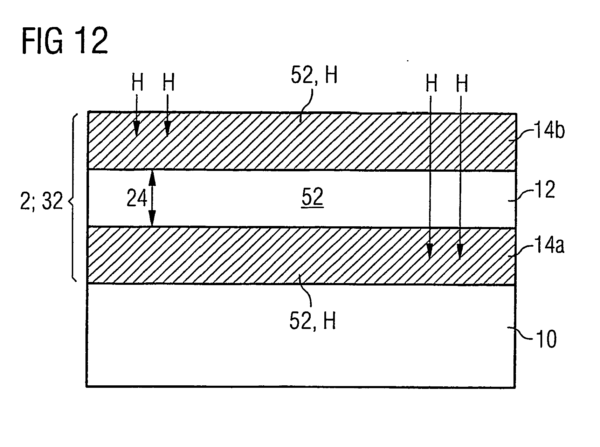

Figur 12 zeigt im Querschnitt ein zur Erfindung alternatives Strukturelement ähnlich wie in Figur 7. Gemäß Figur 12 enthält das Strukturelement 2 ein Grundmaterial 32, das im wesentlichen aus einem paramagnetischen Bestandteil 52 besteht. In ersten Bereichen 14a, 14b außerhalb eines Tiefenbereichs 24 ist das Material 32 des Strukturelements 2 aufgrund eines zusätzlichen Gehalts an Wasserstoff H nicht mehr paramagnetisch, sondern ferromagnetisch. Der Wasserstoff wird beispielsweise durch zwei Implantationsschritte in die Bereiche 14a, 14b eingebracht. Das Strukturelement gemäß Figur 12 besitzt zwei ferromagnetische Schichten, die in der Praxis als komplexere ferromagnetische Schichtenfolgen ausgebildet sein werden.

### Bezugszeichenliste

- 1: Bauteil
- 2: Strukturelement
- 10: Substrat
- 11: Hauptfläche
- 12; 12a, 12b: Zweiter Bereich
- 13: Heterostruktur
- 14; 14a; 14b: Erster Bereich
- 15: Gate-Dielektrikum
- 16: Gate-Elektrode
- 18: Schicht
- 20: Spin-Valve-Transistor
- 21: Magnetfeldsensor
- 22, 32: Grundmaterial
- 23: Magnetische Speicherzelle
- 24: Tiefenbereich
- 25: Integrierte Halbleiterschaltung
- 28: Anderes Grundmaterial
- 34: Endfläche
- 35: Maske
- 42: Ferromagnetischer Bestandteil
- 52: Paramagnetischer Bestandteil
- d1, d2, d3: Schichtdicke
- G: Grundfläche
- H: Wasserstoff
- H': Magnetfeld
- I, II, III: Teil der Grundfläche
- Ia, IIa, IIIa: Teilfläche
- L: Ladungsträger
- M, M': Magnetisierung
- σ: Elektrische Leitfähigkeit
- t2: Erste Tiefe
- t3: Zweite Tiefe
- T: Temperatur
- Tc, Tc': Curie-Temperatur
- T2, T3: Zeitdauer
- x, y: Laterale Richtung
- z: Vertikale Richtung

## Patentansprüche

1. Bauteil (1) mit einem Strukturelement (2), das magnetische Eigenschaften besitzt, die vom Gehalt an Wasserstoff (H) in dem Strukturelement (2) abhängen, wobei das Strukturelement (2) ein Grundmaterial (22; 32), das ein magnetischer Halbleiter ist, und einen Gehalt an Wasserstoff (H) in Form einer Wasserstoff-Dotierung enthält,
**dadurch gekennzeichnet, dass** das Strukturelement (2) aufgrund des Gehalts an Wasserstoff zumindest in einem ersten Bereich (14) eine verringerte Curietemperatur (Tc') besitzt.

2. Bauteil (1) nach Anspruch 1,
**dadurch gekennzeichnet, dass** das Grundmaterial (22; 32) des Strukturelements (2) ein elektrischer Isolator ist.

3. Bauteil nach Anspruch 1 oder 2, **dadurch gekennzeichnet, dass** die elektrische Leitfähigkeit des Strukturelements (2) in Abhängigkeit von dem Gehalt an Wasserstoff in dem Strukturelement räumlich variiert.

4. Bauteil nach einem der Ansprüche 1 bis 3, **dadurch gekennzeichnet, dass** der Wasserstoff (H) in dem Strukturelement (2) in Form von atomaren oder ionischen Wasserstoff, einschließlich Deuterium, vorliegt.

5. Bauteil nach einem der Ansprüche 1 bis 3, **dadurch gekennzeichnet, dass** der Wasserstoff in dem Strukturelement (2) in Form von Komplexen mit Atomen eines Übergangsmetalls oder eines Seltenerdmetalls vorliegt.

6. Bauteil nach einem der Ansprüche 1 bis 5, **dadurch gekennzeichnet, dass** in dem Strukturelement (2) freie Ladungsträger (L) vorhanden sind und dass durch den Gehalt an Wasserstoff (H) ein Teil der freien Ladungsträger (L) passiviert ist.

7. Bauteil nach einem der Ansprüche 1 bis 6, **dadurch gekennzeichnet, dass** das Grundmaterial (22) des Strukturelements (2) überwiegend Galliumarsenid enthält.

8. Bauteil nach einem der Ansprüche 1 bis 7, **dadurch gekennzeichnet, dass** das Strukturelement (2) mit Mangan dotiert ist.

9. Bauteil nach einem der Ansprüche 1 bis 8, **dadurch gekennzeichnet, dass** das Strukturelement (2) eine auf einem Substrat (10) angeordnete Schicht ist.

10. Bauteil nach einem der Ansprüche 1 bis 9, **dadurch gekennzeichnet, dass** das Strukturelement (2) eine Schicht einer auf einem Substrat (10) angeordneten, strukturierten Schichtenfolge ist.

11. Bauteil nach einem der Ansprüche 1 bis 10, **dadurch gekennzeichnet, dass** der Gehalt an Wasserstoff (H) in dem Strukturelement (2) in zumindest einer Richtung (x, y) parallel zu einer Hauptfläche (11) des Strukturelements (2) inhomogen verteilt ist.

12. Bauteil nach einem der Ansprüche 1 bis 11, **dadurch gekennzeichnet, dass** der Gehalt an Wasserstoff (H) in dem Strukturelement (2) in Richtung (z) senkrecht zu einer Hauptfläche (11) des Strukturelements (2) inhomogen ist.

13. Bauteil nach einem der Ansprüche 1 bis 12, **dadurch gekennzeichnet, dass** der Wasserstoff (H) in einem begrenzten Tiefenbereich (24) innerhalb des Strukturelements (2) angeordnet ist.

14. Bauteil nach einem der Ansprüche 1 bis 13, **dadurch gekennzeichnet, dass** der Wasserstoff (H) überwiegend in einem ersten Bereich (14) des Strukturelements (2) angeordnet ist und dass das Strukturelement (2) ferner einen zweiten Bereich (12) aufweist, dessen Gehalt an Wasserstoff geringer ist als der Gehalt an Wasserstoff (H) in dem ersten Bereich (14).

15. Bauteil nach Anspruch 14, **dadurch gekennzeichnet, dass** der erste Bereich (14) zwischen zwei zweiten Bereichen (12a, 12b) angeordnet sind, die weitgehend frei von Wasserstoff sind.

16. Bauteil nach Anspruch 15, **dadurch gekennzeichnet, dass** einer (12b) der beiden zweiten Bereiche (12a, 12b) an eine Schicht (18) aus einem anderen Grundmaterial (28) als dem Grundmaterial (22) des Strukturelements (2) angrenzt und dass der eine (12b) der beiden zweiten Bereiche und die Schicht (18) aus dem anderen Grundmaterial (28) eine ferromagnetische Heterostruktur (13) bilden.

17. Bauteil nach einem der Ansprüche 1 bis 16, **dadurch gekennzeichnet, dass** das Bauteil einen Spin-Valve-Transistor (20), einen Magnetfeldsensor (21), eine magnetische Speicherzelle (23) oder eine integrierte Halbleiterschaltung (25) aufweist.

18. Bauteil nach einem der Ansprüche 14 bis 17, **dadurch gekennzeichnet, dass** das Strukturelement (2) in dem Spin-Valve-Transistor (20), dem Magnetfeldsensor (21), der magnetischen Speicherzelle (23) oder der integrierten Halbleiterschaltung (25) angeordnet ist.

19. Bauteil nach einem der Ansprüche 1 bis 18, **dadurch gekennzeichnet, dass** das Bauteil (1) ein mikroelektronisches Bauelement ist.

20. Bauteil nach einem der Ansprüche 1 bis 19, **dadurch gekennzeichnet, dass** der erste Bereich (14) an eine Endfläche (34) des Strukturelements (2) angrenzt und von der Endfläche (34) aus in das Strukturelement (2) hineinreicht.

21. Bauteil nach Anspruch 20, **dadurch gekennzeichnet, dass** die Endfläche (34) eine Hauptfläche (11) des Strukturelements (2) ist.

22. Bauteil nach einem der Ansprüche 1 bis 21, **dadurch gekennzeichnet, dass** das Strukturelement (2) über einem ersten Teil (I) einer Grundfläche (G) des Strukturelements (2) frei von Wasserstoff ist.

23. Bauteil nach Anspruch 22, **dadurch gekennzeichnet, dass** über einem zweiten Teil (II) der Grundfläche (G) des Strukturelements (2) der erste Bereich (14) sich von der Endfläche (34) bis in eine erste Tiefe (t2) in das Strukturelement (2) hinein erstreckt.

24. Bauteil nach Anspruch 23, **dadurch gekennzeichnet, dass** über einem dritten Teil (III) der Grundfläche (G) des Strukturelements (2) der erste Bereich (14) sich von der Endfläche (34) bis in eine zweite Tiefe (t3), die von der ersten Tiefe (t2) verschieden ist, in das Strukturelement (2) hinein erstreckt.

25. Bauteil nach Anspruch 24, **dadurch gekennzeichnet, dass** der zweite Teilbereich (12) über dem ersten (I), dem zweiten (II) und dem dritten Teil (III) der Grundfläche (G) des Strukturelements (2) jeweils eine unterschiedliche Schichtdicke (d1, d2, d3) besitzt.

26. Verfahren zum Verändern magnetischer Eigenschaften eines Materials, wobei das Verfahren die folgende Schritte aufweist:
- Bereitstellen eines Grundmaterials (22, 32), welches ein magnetischer Halbleiter ist und magnetische Eigenschaften besitzt, die sich bei Einbringen von Wasserstoff (H) in das Grundmaterial (22, 32) verändern, und
- Einbringen einer Dotierung von Wasserstoff (H) in das Grundmaterial (22, 32), wodurch die magnetischen Eigenschaften des Grundmaterials zumindest in einem ersten Bereich (14) des Grundmaterials (22; 32) verändert werden,
wobei das Grundmaterial (22, 32) aufgrund des Gehalts an Wasserstoff zumindest in einem ersten Bereich (14) eine verringerte Curietemperatur (Tc') besitzt.

27. Verfahren nach Anspruch 26, **dadurch gekennzeichnet, dass** das Grundmaterial (22; 32) ein elektrischer Isolator ist.

28. Verfahren nach Anspruch 26 oder 27, **dadurch gekennzeichnet, dass** der Wasserstoff (H) in ein Strukturelement (2) aus dem Grundmaterial (22; 32) implantiert wird.

29. Verfahren nach Anspruch 28, **dadurch gekennzeichnet, dass** der Wasserstoff (H) in einen begrenzten Tiefenbereich (24) des Strukturelements (2) implantiert wird.

30. Verfahren nach einem der Ansprüche 26 bis 29, **dadurch gekennzeichnet, dass**
der Wasserstoff (H) in das Strukturelement (2) eingebracht wird, indem zumindest eine Endfläche (34) des Strukturelements (2) einem wasserstoffhaltigen Plasma (30) ausgesetzt wird.

31. Verfahren nach Anspruch 30, **dadurch gekennzeichnet, dass** eine erste Teilfläche (Ia) der Endfläche (34) des Strukturelements (2) vor einem Kontakt mit dem wasserstoffhaltigen Plasma (30) geschützt wird.

32. Verfahren nach Anspruch 31, **dadurch gekennzeichnet, dass** eine zweite Teilfläche (IIa) der Endfläche (34) des Strukturelements (2) während einer Zeitdauer (T2) dem wasserstoffhaltigen Plasma (30) ausgesetzt wird.

33. Verfahren nach Anspruch 32, **dadurch gekennzeichnet, dass** eine dritte Teilfläche (IIIa) der Endfläche (34) des Strukturelements während einer Zeitdauer (T3) dem wasserstoffhaltigen Plasma (30) ausgesetzt wird.

34. Verfahren nach Anspruch 33, dass die Zeitdauer (T3), während derer die dritte Teilfläche (IIIa) der Endfläche (34) dem wasserstoffhaltigen Plasma (30) ausgesetzt wird, verschieden ist von der Zeitdauer (T2), während derer die zweite Teilfläche (IIa) der Endfläche (34) dem wasserstoffhaltigen Plasma (30) ausgesetzt wird.

35. Verfahren nach einem der Ansprüche 32 bis 34, **dadurch gekennzeichnet, dass** die erste Teilfläche (Ia) der Endfläche (34) durch eine Maske (35) vor einem Kontakt mit dem wasserstoffhaltigen Plasma (30) geschützt wird.

36. Verfahren nach einem der Ansprüche 33 bis 35, **dadurch gekennzeichnet, dass** die dritte Teilfläche (IIIa) der Endfläche (34) des Strukturelements nur zeitweise durch eine Maske (35) vor einem Kontakt mit dem wasserstoffhaltigen Plasma (30) geschützt wird, während die zweite Teilfläche (IIa) der Endfläche (34) dem wasserstoffhaltigen Plasma (30) ausgesetzt wird.

37. Verfahren nach Anspruch 30 bis 36, **dadurch gekennzeichnet, dass** der Wasserstoff so in das Strukturelement (2) eingebracht wird, das der Gehalt an Wasserstoff (H) in dem Strukturelement in mindestens einer Richtung (x, y, z) inhomogen ist.

38. Verfahren nach einem der Ansprüche 28 bis 37, **dadurch gekennzeichnet, dass** durch das Einbringen von Wasserstoff eine magnetisch inhomogene Struktur in dem Strukturelement (2) erzeugt wird.

39. Verfahren nach Anspruch 38, **dadurch gekennzeichnet, dass** die magnetisch inhomogene Struktur erzeugt wird, indem der Wasserstoff (H) durch Ionenstrahlschreiben oder durch eine Maske (35) hindurch in das Strukturelement (2) eingebracht wird.

40. Verfahren nach einem der Ansprüche 26 bis 39, **dadurch gekennzeichnet, dass** zunächst ein Strukturelement (2) aus einem Grundmaterial (22; 32) mit magnetischen Eigenschaften hergestellt wird und dass die magnetischen Eigenschaften des Grundmaterials (22; 32) nachträglich durch das Einbringen des Wasserstoffs (H) in zumindest einem ersten Bereich (14) verändert werden.

41. Verfahren nach einem der Ansprüche 26 bis 40, **dadurch gekennzeichnet, dass** die magnetischen Eigenschaften eines mit Mangan dotierten Grundmaterials (22), vorzugsweise vom Galliumarsenid, durch das Einbringen von Wasserstoff (H) verändert werden.

42. Verfahren nach einem der Ansprüche 26 bis 40, **dadurch gekennzeichnet, dass** durch das Einbringen von Wasserstoff die magnetische Anisotropie das Grundmaterials verändert wird.

43. Verfahren nach einem der Ansprüche 26 bis 42, **dadurch gekennzeichnet, dass** durch das Einbringen von Wasserstoff Komplexe von Wasserstoff mit Atomen der Übergangsmetalle oder der seltenen Erden gebildet werden.

44. Verfahren nach einem der Ansprüche 26 bis 43, **dadurch gekennzeichnet, dass** durch das Einbringen von Wasserstoff Komplexe von Wasserstoff mit Dotieratomen gebildet werden.

45. Verfahren nach einem der Ansprüche 26 bis 44, **dadurch gekennzeichnet, dass** durch das Einbringen von Wasserstoff eine in dem Grundmaterial bereits vorhandene Dotierung gegendotiert wird.

## Claims

1. A component (1) comprising a structural element (2) with magnetic properties which depend on the content of hydrogen (H) in the structural element (2), the structural element (2) comprising a base material (22; 32) which is a magnetic semiconductor, and a content of hydrogen (H) in the form of a hydrogen doping,
**characterized in that** the structural element (2) has a reduced Curie temperature (Tc') due to the content of hydrogen at least in a first area (14).

2. The component (1) according to claim 1, **characterized in that** the base material (22; 32) of the structural element (2) is an electric isolator.

3. The component according to claim 1 or 2, **characterized in that** the electrical conductivity of the structural element (2) varies spatially depending on the content of hydrogen in the structural element.

4. The component according to any of the claims 1 to 3, **characterized in that** the hydrogen (H) is present in the structural element (2) in the form of atomic or ionic hydrogen, including deuterium.

5. The component according to any of the claims 1 to 3, **characterized in that** the hydrogen in the structural element (2) is present in the form of complexes with atoms of a transition metal or of a rare earth metal.

6. The component according to any of the claims 1 to 5, **characterized in that** free charge carriers (L) are present in the structural element (2) and **in that** a part of the free charge carriers (L) is passivated by the content of hydrogen (H).

7. The component according to any of the claims 1 to 6, **characterized in that** the base material (22) of the structural element (2) mainly comprises gallium arsenide.

8. The component according to any of the claims 1 to 7, **characterized in that** the structural element (2) is doped with manganese.

9. The component according to any of the claims 1 to 8, **characterized in that** the structural element (2) is a layer arranged on a substrate (10).

10. The component according to any of the claims 1 to 9, **characterized in that** the structural element (2) is a layer of a structured layer sequence arranged on a substrate (10).

11. The component according to any of the claims 1 to 10, **characterized in that** the content of hydrogen (H) in the structural element (2) is distributed in inhomogenous fashion in at least one direction (x, y) parallel to a main surface (11) of the structural element (2).

12. The component according to any of the claims 1 to 11, **characterized in that** the content of hydrogen (H) in the structural element (2) is inhomogenous in a direction (z) perpendicular to a main surface (11) of the structural element (2).

13. The component according to any of the claims 1 to 12, **characterized in that** the hydrogen (H) is provided within the structural element (2) in a limited depth region (24).

14. The component according to any of the claims 1 to 13, **characterized in that** the hydrogen (H) is disposed mainly in a first area (14) of the structural element (2) and **in that** the structural element (2) further comprises a second area (12) whose content of hydrogen is smaller than the content of hydrogen (H) in the first area (14).

15. The component according to claim 14, **characterized in that** the first area (14) is arranged between two second areas (12a, 12b) which are substantially free of hydrogen.

16. The component according to claim 15, **characterized in that** one (12b) of the two second areas (12a, 12b) adjoins a layer (18) which is made from a base material (28) other than the base material (22) of the structural element (2) and **in that** the one (12b) of the two second areas and the layer (18) made from the other base material (28) form a ferromagnetic hetero structure (13).

17. The component according to any of the claims 1 to 16, **characterized in that** the component comprises a spin valve transistor (20), a magnetic field sensor (21), a magnetic memory cell (23) or an integrated semiconductor circuit (25).

18. The component according to any of the claims 14 to 17, **characterized in that** the structural element (2) is arranged in the spin valve transistor (20), magnetic field sensor (21), magnetic memory cell (23) or integrated semiconductor circuit (25).

19. The component according to any of the claims 1 to 18, **characterized in that** the component (1) is a microelectronic component.

20. The component according to any of the claims 1 to 19, **characterized in that** the first area (14) adjoins an end face (34) of the structural element (2) and starting from the end face (34) extends as far as into the structural element (2).

21. The component according to claim 20, **characterized in that** the end face (34) is a main surface (11) of the structural element (2).

22. The component according to any of the claims 1 to 21, **characterized in that** the structural element (2) is hydrogen-free above a first part (I) of a base area (G) of the structural element (2).

23. The component according to claim 22, **characterized in that** above a second part (II) of the base area (G) of the structural element (2), the first area (14) extends from the end face (34) into the structural element (2) as far as to a first depth (t2).

24. The component according to claim 23, **characterized in that** above a third part (III) of the base area (G) of the structural element (2), the first area (14) extends from the end face (34) into the structural element (2) as far as to a second depth (t3) which differs from the first depth (t2).

25. The component according to claim 24, **characterized in that** the second section (12) above the first (I), second (II) and third (III) parts of the base area (G) of the structural element (2) has a different layer thickness (d1, d2, d3) in each case.

26. A method of changing magnetic properties of a material, the method comprising the following steps:
- providing a base material (22, 32) which is a magnetic semiconductor and has magnetic properties which change upon introducing hydrogen (H) in the base material (22, 32), and
- introducing a doping of hydrogen (H) in the base material (22, 32) whereby the magnetic properties of the base material are changed at least in a first area (14) of the base material (22; 32),
the base material (22, 32) having a reduced Curie temperature (Tc') at least in a first area (14) due to the content of hydrogen.

27. The method according to claim 26, **characterized in that** the base material (22; 32) is an electric isolator.

28. The method according to claim 26 or 27, **characterized in that** the hydrogen (H) is implanted in a structural element (2) made of the base material (22; 32).

29. The method according to claim 28, **characterized in that** the hydrogen (H) is implanted in a limited depth region (24) of the structural element (2).

30. The method according to any of the claims 26 to 29, **characterized in that** the hydrogen (H) is introduced in the structural element (2) by exposing at least an end face (34) of the structural element (2) to a hydrogenous plasma (30).

31. The method according to claim 30, **characterized in that** a first subarea (Ia) of the end face (34) of the structural element (2) is protected against a contact with the hydrogenous plasma (30).

32. The method according to claim 31, **characterized in that** a second subarea (IIa) of the end face (34) of the structural element (2) is exposed to the hydrogenous plasma (30) for a time period (T2).

33. The method according to claim 32, **characterized in that** a third subarea (IIIa) of the end face (34) of the structural element is exposed to the hydrogenous plasma (30) for a time period (T3).

34. The method according to claim 33, **characterized in that** the time period (T3) during which the third subarea (IIIa) of the end face (34) is exposed to the hydrogenous plasma (30) differs from the time period (T2) during which the second subarea (IIa) of the end face (34) is exposed to the hydrogenous plasma (30).

35. The method according to any of the claims 32 to 34, **characterized in that** the first subarea (Ia) of the end face (34) is protected by a mask (35) against a contact with the hydrogenous plasma (30).

36. The method according to any of the claims 33 to 35, **characterized in that** the third subarea (IIIa) of the end face (34) of the structural element is only temporarily protected by a mask (35) against a contact with the hydrogenous plasma (30), whereas the second subarea (IIa) of the end face (34) is exposed to the hydrogenous plasma (30).

37. The method according to claim 30 to 36, **characterized in that** the hydrogen is introduced in the structural element (2) in such a manner that the content of hydrogen (H) in the structural element is inhomogenous in at least one direction (x, y, z).

38. The method according to any of the claims 28 to 37, **characterized in that** a magnetically inhomogenous structure is produced in the structural element (2) by the introduction of hydrogen.

39. The method according to claim 38, **characterized in that** the magnetically inhomogenous structure is produced by introducing the hydrogen (H) in the structural element (2) by ion beam scribing or across a mask (35).

40. The method according to any of the claims 26 to 39, **characterized in that** first a structural element (2) is produced from a base material (22; 32) with magnetic properties and **in that** the magnetic properties of the base material (22; 32) are changed later on by the introduction of the hydrogen (H) in at least one first area (14).

41. The method according to any of the claims 26 to 40, **characterized in that** the magnetic properties of a base material (22) doped with manganese, preferably of gallium arsenide, are changed by the introduction of hydrogen (H).

42. The method according to any of the claims 26 to 40, **characterized in that** the introduction of hydrogen changes the magnetic anisotropy of the base material.

43. The method according to any of the claims 26 to 42, **characterized in that** complexes of hydrogen with atoms of the transition metals or of the rare earths are formed by the introduction of hydrogen.

44. The method according to any of the claims 26 to 43, **characterized in that** complexes of hydrogen with doping atoms are formed by the introduction of hydrogen.

45. The method according to any of the claims 26 to 44, **characterized in that** a doping already present in the base material is counter-doped by the introduction of hydrogen.

## Revendications

1. Composant (1) comprenant un élément de structure (2) qui possède des propriétés magnétiques qui dépendent de la teneur en hydrogène (H) dans l'élément de structure (2), l'élément de structure (2) contenant un matériau de base (22; 32) qui est un semi-conducteur magnétique, et une teneur en hydrogène (H) sous forme d'un dopage d'hydrogène,
**caractérisé en ce que** l'élément de structure (2) possède une température Curie (Tc') réduite au moins dans une première zone (14) en raison de la teneur en hydrogène.

2. Composant (1) selon la revendication 1,
**caractérisé en ce que** le matériau de base (22; 32) de l'élément de structure (2) est un isolant électrique.

3. Composant selon la revendication 1 ou 2, **caractérisé en ce que** la conductivité électrique de l'élément de structure (2) varie spatialement en fonction de la teneur en hydrogène dans l'élément de structure.

4. Composant selon l'une des revendications 1 à 3, **caractérisé en ce que** l'hydrogène (H) est présent dans l'élément de structure (2) sous forme d'hydrogène atomique ou ionique, y compris de deutérium.

5. Composant selon l'une des revendications 1 à 3, **caractérisé en ce que** l'hydrogène est présent dans l'élément de structure (2) sous forme de complexes comprenant des atomes d'un métal de transition ou d'un métal de terre rare.

6. Composant selon l'une des revendications 1 à 5, **caractérisé en ce que** des porteurs de charge libres (L) sont présents dans l'élément de structure (2) et **en ce qu'**une partie des porteurs de charge libres (L) est passivée par la teneur en hydrogène (H).

7. Composant selon l'une des revendications 1 à 6, **caractérisé en ce que** le matériau de base (22) de l'élément de structure (2) contient principalement de l'arséniure de gallium.

8. Composant selon l'une des revendications 1 à 7, **caractérisé en ce que** l'élément de structure (2) est dopé au manganèse.

9. Composant selon l'une des revendications 1 à 8, **caractérisé en ce que** l'élément de structure (2) est une couche disposée sur un substrat (10).

10. Composant selon l'une des revendications 1 à 9, **caractérisé en ce que** l'élément de structure (2) est une couche d'une suite de couches structurée disposée sur un substrat (10).

11. Composant selon l'une des revendications 1 à 10, **caractérisé en ce que** la teneur en hydrogène (H) dans l'élément de structure (2) est répartie de manière inhomogène dans au moins une direction (x, y) parallèle à une surface principale (11) de l'élément de structure (2).

12. Composant selon l'une des revendications 1 à 11, **caractérisé en ce que** la teneur en hydrogène (H) dans l'élément de structure (2) est inhomogène en direction (z) perpendiculaire à une surface principale (11) de l'élément de structure (2).

13. Composant selon l'une des revendications 1 à 12, **caractérisé en ce que** l'hydrogène (H) est disposé dans une zone de profondeur limitée (24) au sein de l'élément de structure (2).

14. Composant selon l'une des revendications 1 à 13, **caractérisé en ce que** l'hydrogène (H) est disposé principalement dans une première zone (14) de l'élément de structure (2) et **en ce que** l'élément de structure (2) présente en outre une deuxième zone (12) dont la teneur en hydrogène est inférieure à la teneur en hydrogène (H) dans la première zone (14).

15. Composant selon la revendication 14, **caractérisé en ce que** la première zone (14) est disposée entre deux deuxièmes zones (12a, 12b) qui sont sensiblement exemptes d'hydrogène.

16. Composant selon la revendication 15, **caractérisé en ce qu'**une (12b) des deux deuxièmes zones (12a, 12b) jouxte une couche (18) composée d'un autre matériau de base (28) que le matériau de base (22) de l'élément de structure (2) et **en ce que** l'une (12b) des deux deuxièmes zones et la couche (18) composée de l'autre matériau de base (28) forment une hétérostructure ferromagnétique (13).

17. Composant selon l'une des revendications 1 à 16, **caractérisé en ce que** le composant présente un transistor à valve de spin (20), un capteur de champ magnétique (21), une cellule de mémoire magnétique (23) ou un circuit intégré à semi-conducteur (25).

18. Composant selon l'une des revendications 14 à 17, **caractérisé en ce que** l'élément de structure (2) est disposé dans le transistor à valve de spin (20), le capteur de champ magnétique (21), la cellule de mémoire magnétique (23) ou le circuit intégré à semi-conducteur (25).

19. Composant selon l'une des revendications 1 à 18, **caractérisé en ce que** le composant (1) est un composant microélectronique.

20. Composant selon l'une des revendications 1 à 19, **caractérisé en ce que** la première zone (14) jouxte une surface terminale (34) de l'élément de structure (2) et s'avance dans l'élément de structure (2) à partir de la surface terminale (34).

21. Composant selon la revendication 20, **caractérisé en ce que** la surface terminale (34) est une surface principale (11) de l'élément de structure (2).

22. Composant selon l'une des revendications 1 à 21, **caractérisé en ce que** l'élément de structure (2) est exempt d'hydrogène au-dessus d'une première partie (I) d'une surface de base (G) de l'élément de structure (2).

23. Composant selon la revendication 22, **caractérisé en ce que**, au-dessus d'une deuxième partie (II) de la surface de base (G) de l'élément de structure (2), la première zone (14) s'étend de la surface terminale (34) jusqu'à une première profondeur (t2) dans l'élément de structure (2).

24. Composant selon la revendication 23, **caractérisé en ce que**, au-dessus d'une troisième partie (III) de la surface de base (G) de l'élément de structure (2), la première zone (14) s'étend de la surface terminale (34) jusqu'à une deuxième profondeur (t3), qui est différente de la première profondeur (t2), dans l'élément de structure (2).

25. Composant selon la revendication 24, **caractérisé en ce que** la deuxième zone partielle (12) possède respectivement une densité de couche différente (d1, d2, d3) au-dessus de la première (I), de la deuxième (II) et de la troisième partie (III) de la surface de base (G) de l'élément de structure (2) .

26. Procédé permettant de modifier des propriétés magnétiques d'un matériau, le procédé présentant les étapes suivantes :
- fourniture d'un matériau de base (22; 32), lequel est un semi-conducteur magnétique et possède des propriétés magnétiques qui se modifient en cas d'introduction d'hydrogène (H) dans le matériau de base (22; 32), et
- introduction d'un dopage d'hydrogène (H) dans le matériau de base (22, 32), ce par quoi les propriétés magnétiques du matériau de base se modifient au moins dans une première zone (14) du matériau de base (22; 32),
le matériau de base (22, 32) possédant une température Curie (Tc') réduite au moins dans une première zone (14) en raison de la teneur en hydrogène.

27. Procédé selon la revendication 26, **caractérisé en ce que** le matériau de base (22; 32) est un isolant électrique.

28. Procédé selon la revendication 26 ou 27, **caractérisé en ce que** l'hydrogène (H) est implanté dans un élément de structure (2) composé du matériau de base (22; 32).

29. Procédé selon la revendication 28, **caractérisé en ce que** l'hydrogène (H) est implanté dans une zone de profondeur limitée (24) de l'élément de structure (2).

30. Procédé selon l'une des revendications 26 à 29, **caractérisé en ce que** l'hydrogène (H) est introduit dans l'élément de structure (2) **en ce qu'**au moins une surface terminale (34) de l'élément de structure (2) est exposée à un plasma hydrogéné (30).

31. Procédé selon la revendication 30, **caractérisé en ce qu'**une première surface partielle (Ia) de la surface terminale (34) de l'élément de structure (2) est protégé contre un contact avec le plasma hydrogéné (30).

32. Procédé selon la revendication 31, **caractérisé en ce qu'**une deuxième surface partielle (IIa) de la surface terminale (34) de l'élément de structure (2) est exposée au plasma hydrogéné (30) pendant une période de temps (T2).

33. Procédé selon la revendication 32, **caractérisé en ce qu'**une troisième surface partielle (IIIa) de la surface terminale (34) de l'élément de structure est exposée au plasma hydrogéné (30) pendant une période de temps (T3).

34. Procédé selon la revendication 33, **caractérisé en ce que** la période de temps (T3) pendant laquelle la troisième surface partielle (IIIa) de la surface terminale (34) est exposée au plasma hydrogéné (30), est différente de la période de temps (T2) pendant laquelle la deuxième surface partielle (IIa) de la surface terminale (34) est exposée au plasma hydrogéné (30).

35. Procédé selon l'une des revendications 32 à 34, **caractérisé en ce que** la première surface partielle (Ia) de la surface terminale (34) est protégée par un masque (35) contre un contact avec le plasma hydrogéné (30).

36. Procédé selon l'une des revendications 33 à 35, **caractérisé en ce que** la troisième surface partielle (IIIa) de la surface terminale (34) de l'élément de structure n'est qu'épisodiquement protégée par un masque (35) contre un contact avec le plasma hydrogéné (30) pendant que la deuxième surface partielle (IIa) de la surface terminale (34) est exposée au plasma hydrogéné (30).

37. Procédé selon l'une des revendications 30 à 36, **caractérisé en ce que** l'hydrogène est introduit dans l'élément de structure (2) de telle façon que la teneur en hydrogène (H) dans l'élément de structure soit inhomogène dans au moins une direction (x, y, z).

38. Procédé selon l'une des revendications 28 à 37, **caractérisé en ce qu'**une structure magnétiquement inhomogène est produite dans l'élément de structure par l'introduction d'hydrogène.

39. Procédé selon la revendication 38, **caractérisé en ce que** la structure magnétiquement inhomogène est produite **en ce que** l'hydrogène (H) est introduit au travers de l'élément de structure (2) par inscription de rayons ioniques ou par un masque (35).

40. Procédé selon l'une des revendications 26 à 39, **caractérisé en ce qu'**un élément de structure (2) composé du matériau de base (22; 32) présentant des propriétés magnétiques est d'abord fabriqué et **en ce que** les propriétés magnétiques du matériau de base (22; 32) sont modifiées ultérieurement par l'introduction de l'hydrogène (H) dans au moins une première zone (14).

41. Procédé selon l'une des revendications 26 à 40, **caractérisé en ce que** les propriétés magnétiques d'un matériau de base (22) dopé au manganèse, de préférence de l'arséniure de gallium, sont modifiées par l'introduction d'hydrogène (H).

42. Procédé selon l'une des revendications 26 à 40, **caractérisé en ce que** l'anisotropie magnétique du matériau de base est modifié par l'introduction d'hydrogène.

43. Procédé selon l'une des revendications 26 à 42, **caractérisé en ce que** des complexes d'hydrogène comprenant des atomes des métaux de transition ou des terres rares sont formés par l'introduction d'hydrogène.

44. Procédé selon l'une des revendications 26 à 43, **caractérisé en ce que** des complexes d'hydrogène comprenant des atomes de dopage sont formés par l'introduction d'hydrogène.

45. Procédé selon l'une des revendications 26 à 44, **caractérisé en ce qu'**un dopage déjà présent dans le matériau de base est contre-dopé par l'introduction d'hydrogène.
